# EUROPÄISCHE PATENTSCHRIFT

(11) **EP 1 641 894 B1**
(45) Veröffentlichungstag und Bekanntmachung des Hinweises auf die Patenterteilung: **21.01.2009**
(21) Anmeldenummer: 04740246.6
(22) Anmeldetag: 24.06.2004
(51) Int. Cl.: C09K 11/06, H05B 33/14, H01L 51/30, C08G 61/12, C07D 209/86

(54) **NEUE MATERIALIEN FÜR DIE ELEKTROLUMINESZENZ**
NOVEL MATERIALS FOR ELECTROLUMINESCENCE
NOUVEAUX MATERIAUX UTILISES EN ELECTROLUMINESCENCE

(30) Priorität: 26.06.2003 DE 10328627
(43) Veröffentlichungstag der Anmeldung: 05.04.2006
(73) Patentinhaber: Merck Patent GmbH, 64293 Darmstadt (DE)
(72) Erfinder: BREUNING, Esther, 65817 Eppstein-Niederjosbach (DE); FALCOU, Aurelie, 60322 Frankfurt (DE); HEUN, Susanne, 65812 Bad Soden (DE); PARHAM, Amir, 65929 Frankfurt (DE)
(86) Internationale Anmeldenummer: PCT/EP2004/006832
(87) Internationale Veröffentlichungsnummer: WO 2004/113468

(56) Entgegenhaltungen:
- WO-A-02/077060
- US-A- 4 111 850
- US-A- 4 125 534
- US-A1- 2003 017 361
- DATABASE WPI Section Ch, Week 197639 Derwent Publications Ltd., London, GB; Class A41, AN 1976-73516X XP002299357 & SU 474 533 A (TOMSK KIROV POLY) 12. März 1976 (1976-03-12)

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit Markt beherrschenden Flüssigkristallanzeigen (LCD) zu machen. Vor allem ist es hierbei erforderlich, Verbindungen für alle Emissionsfarben (Rot, Grün, Blau) zur Verfügung zu stellen, die den Anforderungen des Marktes (Effizienz, operative Lebensdauer und Betriebsspannung, um die wichtigsten zu nennen) gerecht werden.

Als Polymere für vollfarbige Anzeigeelemente (sog. Full-Colour-Displays) wurden verschiedene Materialklassen vorgeschlagen bzw. entwickelt. So kommen Polyfluorenderivate, wie beispielsweise in EP 0842208, WO 99/54385, WO 00/22027, WO 00/22026 und WO 00/46321 offenbart, in Betracht. Des Weiteren sind auch Poly-Spirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im Allgemeinen sind für derartigen Einsatz Polymere, welche Poly-para-Phenylen (PPP) als Strukturelement enthalten, möglich. Neben den oben bereits genannten Klassen kommen hier beispielsweise auch die so genannten Leiter-PPPs ("Ladder-PPPs" = L-PPP, z. B. gemäß WO 92/18552), die Poly-Tetrahydropyrene (z. B. gemäß EP 699699), aber auch Ansa-Strukturen enthaltende PPPs (z. B. gemäß EP 690086) in Frage.

Des Weiteren wurde berichtet, dass das Einfügen bestimmter Arylaminogruppierungen eine Verbesserung der Eigenschaften ergibt: WO 99/54385 und DE 19846767 beschreiben Polyfluorene, deren Effizienz und Einsatzspannung verbessert werden können, indem Derivate von Triphenylamin, Tetraphenyl-p-diaminobenzol, Tetraphenyl-4,4'-diaminobiphenyl oder substituierte Diarylaminoeinheiten in die Hauptkette der entsprechenden Polymere mit einpolymerisiert werden. WO 01/66618 beschreibt Copolymere, welche neben Aryleinheiten auch spezielle Triarylamino- bzw. Tetraaryl-p-diaminoarylen-Einheiten in der Hauptkette enthalten.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6). Diese Verbindungen werden im Folgenden als "Triplett-Emitter" bezeichnet. Aus theoretischen Spin-statistischen Überlegungen ist unter Verwendung solcher Triplett-Emitter eine bis zu vierfache Energie- und Leistungseffizienz möglich. Ob sich diese Entwicklung durchsetzen wird, hängt stark davon ab, ob entsprechende Device-Kompositionen gefunden werden, die diese Vorteile (Triplett-Emission = Phosphoreszenz gegenüber Singulett-Emission = Fluoreszenz) auch in OLEDs umsetzen können. Als wesentliche Bedingungen für die praktische Anwendung sind hier insbesondere ein effizienter Energieübertrag auf den Triplett-Emitter (und damit verbunden effiziente Lichtemission), eine hohe operative Lebensdauer und eine niedrige Einsatz- und Betriebsspannung, um mobile Applikationen zu ermöglichen, zu nennen.
In letzter Zeit gibt es intensive Bemühungen, sich die Vorteile aufdampfbarer niedermolekularer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und die durch Mischen des Triplett-Emitters in das Polymer entstehen. Andererseits kann der Triplett-Emitter auch kovalent an das Polymer gebunden werden. Beide Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (v. a. mit Hilfe hochauflösender Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie. Lösliche Triplett-Emitter werden beispielsweise in WO 04/026886 offenbart. Jedoch ist auch hierfür ein geeignetes Matrix-Material notwendig, das einen effizienten Energietransfer auf den Triplett-Emitter ermöglicht.

Bekannt ist weiterhin, dass Blends (Mischungen) nicht-konjugierter Polymere, wie z. B. PVK (Poly-Vinylcarbazol), mit metallorganischen Triplett-Emittern in effizienter Elektrolumineszenz des Metallkomplexes resultieren (z. B. Chen et al., Appl. Phys. Lett. 2002, 80, 2308). Jedoch sind die Betriebsspannungen für diese Systeme sehr hoch, was in einer sehr niedrigen Leistungseffizienz resultiert und somit keine kommerzielle Anwendung dieser Systeme ermöglicht.
Blends solcher Metallkomplexe mit konjugierten Polymeren sind in der Literatur ebenfalls beschrieben. Guo et al. (Organic Electronics 2000, 1, 15) und O'Brien et al. (Synth. Met. 2001, 116, 379) beschreiben gute Quanteneffizienzen mit Blends aus einem Platin-Porphyrin-Komplex mit Polyfluorenen, wobei in beiden Fällen die Effizienzen deutlich niedriger sind als bei vergleichbaren Devices, aufgebaut aus aufgedampften niedermolekularen Verbindungen. Zhu et al. (Appl. Phys. Lett. 2002, 80, 2045) beschreiben einen Blend aus einem löslichen Iridium-Phenylpyridin-Komplex mit einem Poly-para-Phenylen. Hier wurden bessere, aber weiterhin relativ niedrige Quanteneffizienzen gemessen. Insbesondere wurden hier sehr hohe Spannungen benötigt, die einer technischen Anwendung im Wege stehen.

Polymere, die neben Fluoren- und Spirobifluoren-Einheiten zusätzlich noch Triplett-Emitter in der Haupt- bzw. Seitenkette enthalten werden in der WO 02/077060 offenbart.

Die Verwendung von niedermolekularen Carbazol-Derivaten bzw. von Polyvinylcarbazolen als Host-Materiallen in lichtemittierenden Schichten von OLEDs wird in der US 2003/0017361 A1 beschrieben.

Carbazol-Derivate der beiden folgenden Formeln 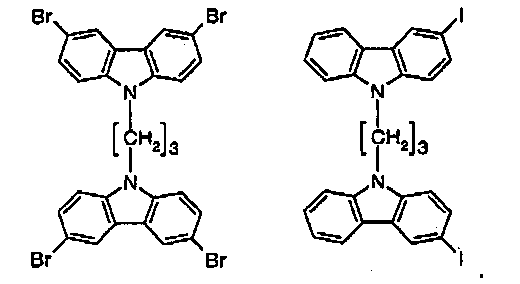 werden in der US 4,117,850 offenbart.

Carbazol-Derivate der folgenden Formel, die zwei Acetylen-Gruppen enthalten, 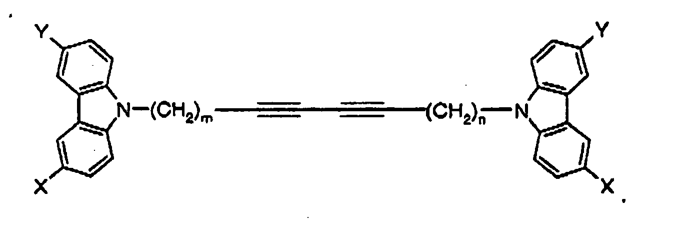 worin m und n ganze Zahlen von 0 bis 10 und X und Y unabhängig voneinander H, Cl, Br oder NO₂ sein können, werden in der US 4,125,534 offenbart.

Carbazol-Derivate der folgenden Formel 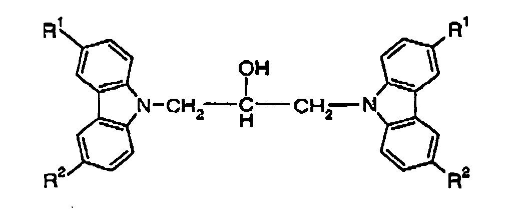 worin R¹ und R² H oder Halogen sein können, werden in der SU 474533 offenbart.

Trotz der in den o. g. Publikationen und Anmeldeschriften zitierten Fortschritte gibt es also immer noch einen erheblichen Verbesserungsbedarf für entsprechende Materialien, u. a. auf folgenden Feldern:
(1) Die Effizienz der Lichtemission muss noch weiter gesteigert werden. Dafür ist effizienterer Energie-Transfer auf den Triplett-Emitter und somit ein geeigneteres Matrix-Material notwendig. Dass höhere Effizienzen prinzipiell möglich sind, zeigen die Ergebnisse mit aufgedampften niedermolekularen Triplett-Emittern.
(2) Die Strom-Spannungs-Kennlinien müssen noch steiler werden, damit große Helligkeit bei niedrigen Spannungen erzielt und somit die Leistungseffizienz gesteigert wird. Dies ist von enormer Bedeutung, da somit einerseits gleiche Helligkeit bei geringerem Energieverbrauch erzielt werden kann, was vor allem bei mobilen Applikationen (Displays für Handys, Pager, PDA, etc.) sehr wichtig ist. Andererseits erhält man bei gleichem Energieverbrauch höhere Helligkeiten, was beispielsweise für Beleuchtungsanwendungen interessant sein kann. Bei Verbindungen, die dem Stand der Technik entsprechen, sind die Betriebsspannungen noch deutlich zu hoch, was in einer relativ niedrigen Leistungseffizienz resultiert.

Wir haben nun überraschend gefunden, dass - bisher unbekannte - konjugierte Polymere und Mischungen, die bestimmte überbrückte Carbazoleinheiten enthalten, in Verbindung mit Triplett-Emittern deutliche Verbesserungen, gerade auf den beiden o. g. Gebieten, also der Effizienz der Lichtemission und der Betriebsspannung, im Vergleich zu Blends oder Polymeren gemäß Stand der Technik ergeben. Diese Materialien sind daher Gegenstand der vorliegenden Anmeldung.
Gegenstand der Erfindung sind Mischungen, enthaltend
(A) mindestens ein konjugiertes Polymer,
(B) mindestens eine überbrückte Carbazoleinheit der Formel (I) 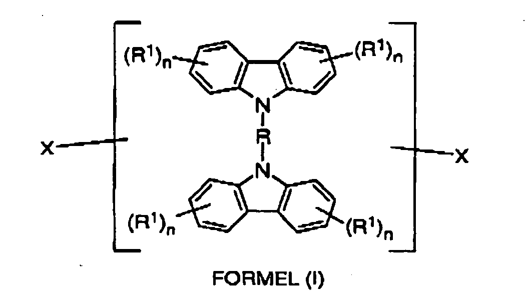 wobei die Symbole und Indizes folgende Bedeutung besitzen:
   - R: ist bei jedem Auftreten gleich oder verschieden eine geradkettige, verzweigte oder cyclische Alkylenkette mit 1 bis 40 C-Atomen, die mit R¹ substituiert oder unsubstituiert sein kann, in der auch ein oder mehrere nicht benachbarte C-Atome durch -NR²-, -O-, -S-, -CO-, -CO-O-, -CO-NR²-, -O-CO-O- ersetzt sein können, ein bivalentes aromatisches oder heteroaromatisches Ringsystem mit 2 bis 40 C-Atomen, welches mit R¹ substituiert oder unsubstituiert sein kann, eine mit R¹ substituierte oder unsubstituierte Vinyleneinheit, eine Acetyleneinheit oder eine Kombination aus 2 bis 5 dieser Systeme; die aromatischen Einheiten können dabei auch Teil eines größeren kondensierten Systems bilden; die möglichen Substituenten R¹ können optional an jeder freien Position sitzen;
   - R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -NR²-, -O-, -S-, -CO-O-, -O-CO-O- ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R¹ substituiert sein kann, eine Vinyl- oder Acetylengruppe oder F, Cl, Br, I, NO₂, CN, N(R²)₂, B(R²)₂, Si(R²)₃, wobei auch zwei oder mehrere Reste R' miteinander ein aliphatisches oder aromatisches, mono- oder polycyclisches Ringsystem bilden können;
   - R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können und welche auch durch einen oder mehrere nicht-aromatische Reste R² substituiert sein kann; dabei können auch zwei oder mehrere Reste R² miteinander ein Ringsystem bilden;
   - n: ist bei jedem Auftreten gleich oder verschieden 0, 1, 2, 3 oder 4, mit der Maßgabe, dass n nicht 4 sein darf, wenn eine Verknüpfung mit der Polymerkette (also X) an dieser Phenyleinheit erfolgt, und dass n nicht 3 oder 4 sein darf, wenn beide Verknüpfungen mit der Polymerkette (also X) an dieser Phenyleinheit erfolgen;
   - X: beschreibt die Verknüpfung mit dem konjugierten Polymer,
   und/oder der Formel (II) 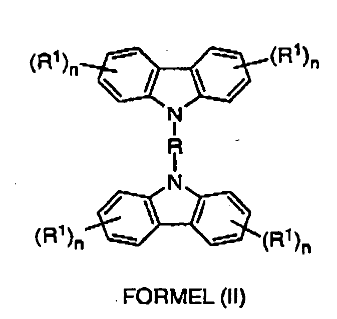 wobei die Symbole R, R¹, R² und die Indizes n dieselbe Bedeutung wie unter Formel (I) besitzen.
   und
(C) mindestens einen Triplett-Emitter.

Als Triplett-Emitter im Sinne der Erfindung werden Verbindungen verstanden, die aus dem Triplett-Zustand Licht emittieren, also in der Elektrolumineszenz Phosphoreszenz statt Fluoreszenz zeigen, bevorzugt organische oder metallorganische Triplett-Emitter, die niedermolekular, oligomer, dendritisch oder polymer sein können. Ohne an eine bestimmte Theorie gebunden sein zu wollen, werden im Sinne dieser Erfindung alle emittierenden Metallkomplexe, enthaltend Übergangsmetalle oder Lanthanoide, als Triplett-Emitter bezeichnet.

Vorzugsweise enthält die erfindungsgemäße Mischung mindestens 0.5 Gew.% mindestens eines konjugierten Polymeren, mindestens 1 Gew.% mindestens einer überbrückten Carbazoleinheit und mindestens 0.5 Gew.% mindestens eines Triplett-Emitters.

Eine Ausführungsform der Erfindung sind Mischungen BLEND1, enthaltend
(A) 5 - 99.5 Gew.% mindestens eines konjugierten Polymers POLY1, das 1 - 100 mol%, bevorzugt 10 -100 mol%, besonders bevorzugt 20 -100 mol% einer oder mehrerer Einheiten gemäß Formel (I) enthält, 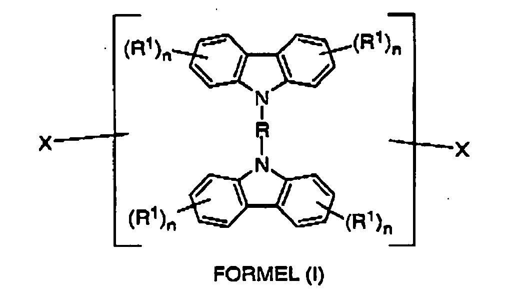 wobei die Symbole und Indizes dieselbe Bedeutung besitzen, wie oben beschrieben, und
(B) 0.1 - 95 Gew.%, bevorzugt 0.5 - 80 Gew.%, besonders bevorzugt 1 - 50 Gew.%, insbesondere 2 - 25 Gew.%, eines oder mehrerer Triplett-Emitter (VERB1).

In der Ausführungsform BLEND 1 ist der Triplett-Emitter (VERB1) nicht-kovalent zu dem Polymer POLY1 gemischt.

Eine bevorzugte Ausführungsform ist der Einbau der Einheiten gemäß Formel (I) in das Polymer über die 3,6- oder die 2,7-Position einer Carbazoleinheit (X=Verknüpfung), so dass eine der beiden Carbazoleinheiten in die Hauptkette eingebaut wird, während die andere eine Seitenkette des Polymers darstellt.
Eine weitere bevorzugte Ausführungsform ist der Einbau der Einheiten gemäß Formel (I) in das Polymer über die 2,2'-, die 3,3'- oder die 2,3'-Positionen beider Carbazoleinheiten (X=Verknüpfung), falls R eine aromatische oder heteroaromatische Einheit, eine Vinylen- oder Acetyleneinheit oder eine Kombination dieser Einheiten beschreibt. In diesem Fall sind beide Carbazoleinheiten in die Hauptkette des Polymers eingebaut.
Eine weitere bevorzugte Ausführungsform ist der Einbau (X=Verknüpfung) der Einheiten gemäß Formel (I) in das Polymer über R selbst oder über R¹, sofern diese aromatische oder heteroaromatische Einheiten enthalten, so dass ein konjugiertes Polymer entsteht. In diesem Fall bilden beide Carbazole Seitenketten des Polymers. Die Verknüpfung kann auch über einen Phenylring einer Carbazol-Einheit erfolgen, beispielsweise über die Positionen 1 und 4 oder 1 und 2. Zur Klarheit wird die Nummerierung des Carbazols in folgender Struktur aufgezeigt; die im Text mit einem Strich gekennzeichneten Positionen stellen die entsprechenden Atome an der jeweils anderen Carbazoleinheit dar:

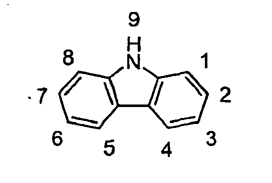

Eine weitere Ausführungsform der Erfindung sind Mischungen BLEND2, enthaltend
(A) 0.5 - 99 Gew.% mindestens eines konjugierten Polymers POLY2, das 0.1 - 100 mol%, vorzugsweise 0.5 bis 80 mol% eines oder mehrerer Triplett-Emitter (VERB2) kovalent gebunden enthält, und
(B) 1 - 99.5 Gew.% mindestens einer Verbindung der Struktureinheit gemäß Formel (II) 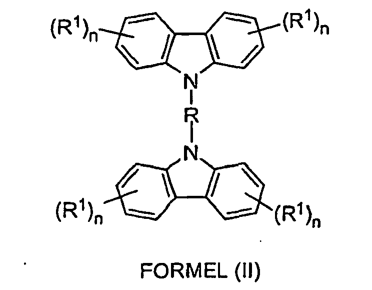
wobei die Symbole und Indizes dieselbe Bedeutung haben, wie oben beschrieben.

Eine bevorzugte Ausführungsform BLEND 2 besteht darin, dass der Triplett-Emitter in die Haupt- und/oder in die Seitenkette des Polymers POLY2 eingebaut ist.

Ein weiterer Aspekt dieser Erfindung sind Mischungen BLEND3, enthaltend
(A) 0.5 - 98.5 Gew.% mindestens eines beliebigen konjugierten Polymers POLY3; und
(B) 1 - 99 Gew.%, bevorzugt 10 - 90 Gew.% mindestens einer Struktureinheit gemäß Formel (II) 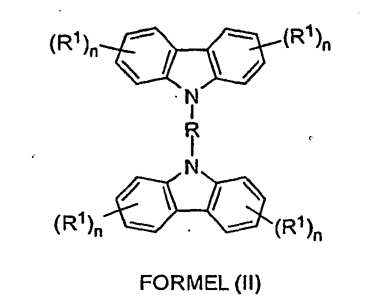 wobei die Symbole und Indizes dieselbe Bedeutung wie oben besitzen; und
(C) 0.1 - 95 Gew.%, bevorzugt 0.5 - 80 Gew.%, besonders bevorzugt 1 - 50 Gew.%, insbesondere 2 - 25 Gew.%, eines oder mehrerer Triplett-Emitter VERB1.

Ein weiterer Aspekt dieser Erfindung sind Mischungen BLEND4, enthaltend
(A) 0.5 - 98.5 Gew.% mindestens eines beliebigen konjugierten Polymers POLY3; und außerdem
(B) 1.5 - 99.5 Gew.% einer Verbindung VERB3, die einen oder mehrere Triplett-Emitter kovalent an mindestens eine Struktureinheit gemäß Formel (II) gebunden enthält, 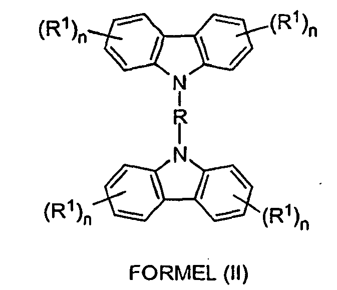
wobei die Symbole und Indizes dieselbe Bedeutung wie oben besitzen und die Bindung zwischen dem Triplett-Emitter und der Struktureinheit gemäß Formel (II) an beliebigen Positionen des Triplett-Emitters und der Struktureinheit gemäß Formel (II) erfolgen kann.

Als Triplett-Emitter (VERB1 bzw. VERB3) kommen, wie oben erwähnt, auch Dendrimere in Frage. Darunter soll in diesem Zusammenhang eine hochverzweigte Verbindung verstanden werden, die aus einem multifunktionellen Zentrum (core) aufgebaut ist; an das in einem regelmäßigen Aufbau verzweigte Monomere gebunden werden, so dass eine baumartige Struktur entsteht. Dabei können sowohl das Zentrum, als auch die Monomere verzweigte Strukturen annehmen, die sowohl aus rein organischen Einheiten, als auch Organometallverbindungen oder Koordinationsverbindungen bestehen. Dendrimer soll hier allgemein so verstanden werden, wie dies beispielsweise in M. Fischer, F. Vögtle, Angew. Chem. Int. Ed. 1999, 38, 885-905 beschrieben ist.

Konjugierte Polymere im Sinne dieser Erfindung sind Polymere, die in der Hauptkette hauptsächlich sp²-hybridisierte (bzw. teilweise auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, wie beispielsweise das Carbazol-Dimer gemäß Formel (I) oder andere derartige Einheiten und/oder bestimmte Heterocyclen (d. h. Konjugation über N-, O-, oder S-Atome) und/oder metallorganische Komplexe, wie beispielsweise Einheiten gemäß VERB2 (d. h. Konjugation über das Metallatom), befinden. Hingegen würden Einheiten wie beispielsweise einfache (Thio)Etherbrücken, Alkylenketten, Ester-, Amid- oder Imidverknüpfungen eindeutig als nicht-konjugierte Segmente definiert.

Die Polymere POLY1, POLY2 und POLY3 können außer den Struktureinheiten gemäß Formel (I) (in POLY1) und dem Triplett-Emitter VERB2 (in POLY2) verschiedene weitere Strukturelemente enthalten. Dies sind u. a. solche, wie sie in den o. g. Patentanmeldungen bereits offenbart sind. Hier sei vor allem auch auf die relativ umfangreiche Auflistung in WO 02/077060 verwiesen; diese wird via Zitat als Bestandteil der vorliegenden Erfindung betrachtet. Diese Struktureinheiten können beispielsweise aus den im Folgenden beschriebenen Klassen stammen:
1. Struktureinheiten, die das Polymergrundgerüst bilden können:
   - Hier sind zunächst Phenylene und davon abgeleitete Strukturen zu nennen. Dies sind beispielsweise (jeweils substituierte oder unsubstituierte) ortho-, meta- oder para-Phenylene, 1,4-Naphthylene, 9,10-Anthracenylene, 2,7-Phenanthrenylene, 1,6- bzw. 2,7- bzw. 4,9-Pyrene oder 2,7-Tetrahydropyrene. Auch entsprechende heterocyclische Poly-Arylen-bildende Strukturen, wie beispielsweise 2,5-Thiophenylen, 2,5-Pyrrolylen, 2,5-Furanylen, 2,5-Pyridylen, 2,5-Pyrimidinylen oder 5,8-Chinolinylen kommen in Frage.
   - Des Weiteren sind komplexere Einheiten, wie die o. g. Fluorene, Spiro-9,9'-bifluorene, mehrfach überbrückte Einheiten (z. B. Teilsegmente der o. g. L-PPP-Polymere), aber auch "doppelte Fluoren"-Einheiten (Indenofluorene) möglich. Auch diese können substituiert bzw. unsubstituiert sein. Auch entsprechende heterocyclische Strukturen, in denen beispielsweise einzelne Ringkohlenstoffatome durch Heteroatome wie beispielsweise Schwefel oder Stickstoff ersetzt sind, kommen hier in Frage.
2. Struktureinheiten, die die Ladungsinjektions- bzw. Ladungstransporteigenschaften beeinflussen:
   Dies kann sich sowohl auf die Elektroneninjektions- oder -transporteigenschaften (wie beispielsweise Oxadiazoleinheiten) wie auch auf die Lochinjektions- oder -transporteigenschaften (wie beispielsweise Triarylamineinheiten) beziehen. Hier sei nochmals auf die umfangreiche Auflistung derartiger Struktureinheiten in der oben zitierten Anmeldeschrift WO 02/077060 verwiesen. Ebenso kommen für diesen Zweck Naphthylarylamine, wie sie in der nicht offen gelegten Anmeldeschrift DE 10249723.0 beschrieben werden, oder Carbazole, wie sie in der nicht offen gelegten Anmeldeschrift DE 10304819.7 beschrieben werden, in Frage.

Die Polymere POLY1, POLY2 und POLY3 sind Homopolymere oder es sind Copolymere. Die Copolymere können sowohl statistische, als auch teilstatistische, alternierende oder auch blockartige Strukturen aufweisen oder auch mehrere dieser Strukturen abwechselnd besitzen. Ebenso können sie sowohl linear, als auch verzweigt oder dendritisch aufgebaut sein. Durch das Verwenden mehrerer verschiedener Strukturelemente können Eigenschaften wie Löslichkeit, Festphasenmorphologie, etc. eingestellt werden.

Die Polymere POLY1, POLY2 und POLY3 weisen in der Regel 10 bis 10000, bevorzugt 50 bis 5000, besonders bevorzugt 50 bis 2000 Wiederholeinheiten auf. Dabei beträgt die Polydispersität PD bevorzugt weniger als 10, besonders bevorzugt weniger als 5.

Die nötige Löslichkeit der Polymere wird v. a. durch die Substituenten R¹ an den verschiedenen Monomereinheiten in entsprechenden Polymeren erreicht.

Die Polymere POLY1, POLY2 und POLY3 werden in der Regel durch Polymerisation von einem oder mehreren Monomeren hergestellt.
Entsprechende Polymerisationsreaktionen gibt es prinzipiell viele. Es haben sich hier jedoch insbesondere einige Typen bewährt, die zu C-C-Verknüpfungen (SUZUKI-Kupplung, YAMAMOTO-Kupplung, STILLE-Kupplung) oder zu C-N-Verknüpfungen (HARTWIG-BUCHWALD-Kupplung) führen. Wie die Polymerisation nach diesen Methoden durchgeführt werden kann und wie die Polymere dann vom Reaktionsmedium abgetrennt und aufgereinigt werden können, ist beispielsweise im Detail beschrieben in DE 10249723.0.

Um die entsprechenden Polymere POLY1, POLY2 und POLY3 herstellen zu können, benötigt man - wie beschrieben - die entsprechenden Monomere.

Die Synthese.möglicher Co-Monomere ist in den bereits oben genannten Anmeldeschriften und Patenten ausführlich beschrieben. Einen guten Überblick hierzu gibt dabei die Anmeldeschrift WO 02/077060.

Die Struktureinheit gemäß Formel (I) ist Bestandteil von POLY1. Es hat sich gezeigt, dass ein Anteil im Bereich von 10 - 99 mol% Struktureinheiten gemäß Formel (I) hier gute Ergebnisse erzielt. Bevorzugt ist also für POLY1 bzw. BLEND1 ein Anteil von 10 - 99 mol% Struktureinheiten gemäß Formel (I). Besonders bevorzugt ist ein Anteil von 20 - 99 mol% Struktureinheiten gemäß Formel (I).

Die Struktureinheit gemäß Formel (II) ist Bestandteil von BLEND2 und BLEND3. Es hat sich gezeigt, dass ein Anteil im Bereich von 5 - 99 Gew.% Struktureinheiten gemäß Formel (II) hier gute Ergebnisse erzielt. Bevorzugt ist also für BLEND2 und BLEND3 ein Anteil von 5 - 99 Gew.% Struktureinheiten gemäß Formel (II). Besonders bevorzugt ist ein Anteil von 10 - 99 Gew.% Struktureinheiten gemäß Formel (II), ganz besonders bevorzugt ist ein Anteil von 20 - 99 Gew.%.

Eine weitere bevorzugte Ausführungsform ist das Einmischen von Struktureinheiten gemäß Formel (II) in BLEND1, so dass hier überbrückte Carbazol-Einheiten sowohl kovalent gebunden als auch eingemischt vorliegen. Hier hat sich gezeigt, dass ein Gesamtanteil von 10 - 99 mol% Struktureinheiten gemäß Formel (I) bzw. Formel (II) gute Ergebnisse erzielt, unabhängig davon, ob diese Einheiten kovalent an das konjugierte Polymer gebunden oder eingemischt sind. Bevorzugt ist hier also ein Gesamtanteil von 10 - 99 mol% Struktureinheiten gemäß Formel (I) und (II). Besonders bevorzugt ist ein Gesamtanteil von 20 - 99 mol% Struktureinheiten gemäß Formel (I) und Formel (II).

Eine weitere bevorzugte Ausführungsform ist das Einmischen von Struktureinheiten gemäß Formel (II) in BLEND4, so dass hier die Carbazol-Dimer-Einheiten sowohl kovalent an den Triplett-Emitter gebunden wie auch eingemischt vorliegen. Auch hier hat sich gezeigt, dass ein Gesamtanteil von 10 - 99 mol% Struktureinheiten gemäß Formel (II) gute Ergebnisse erzielt, unabhängig davon, ob diese Einheiten kovalent an den Triplett-Emitter gebunden sind oder eingemischt sind. Bevorzugt ist hier also ein Gesamtanteil von 10 - 99 mol% Struktureinheiten gemäß Formel (II). Besonders bevorzugt ist ein Gesamtanteil von 20 - 99 mol% Struktureinheiten gemäß Formel (II).

Für bevorzugte Strukturen gemäß Formel (I) gilt Folgendes:
- R: ist bei jedem Auftreten gleich oder verschieden eine geradkettige, verzweigte oder cyclische Alkylenkette mit 2 bis 20 C-Atomen, die mit R¹ substituiert oder unsubstituiert sein kann, in der auch ein oder mehrere nicht benachbarte C-Atome durch -NR²-, -O-, -S-, -CO-, -CO-O-, -CO-NR²- oder -O-CO-O ersetzt sein können, ein bivalentes aromatisches oder heteroaromatisches Ringsystem, ausgewählt aus Thiophen, Benzothiophen, Benzol, Biphenyl, Pyridin, Chinoxalin, Fluoren, Spirobifluoren, Naphthalin, Anthracen, Pyren, Phenanthren, Dihydrophenanthren, welches an den freien Positionen 0 bis 4 Substituenten R¹ trägt, ein Stilbenylen- oder Tolanylensystem, welches an den freien Positionen 0 bis 4 Substituenten R¹ trägt, oder Kombinationen aus 2 bis 5 dieser Systeme;
- R¹, R², n: sind analog den oben gemachten Angaben;
die Verknüpfung in POLY1 erfolgt bevorzugt über die 3,6- oder 2,7-Position, über die 2,2'-oder 3,3'-Position, sofern R eine aromatische oder heteroaromatische Einheit oder eine Stilbenyl- oder Tolanyleinheit ist, oder über die Gruppe R oder R¹, sofern R bzw. R¹ eine aromatische oder heteroaromatische Einheit oder eine Stilbenyl- oder Tolanyleinheit ist, so dass eine gerade Anzahl aromatischer Atome zwischen den Verknüpfungspunkten liegt.

Für besonders bevorzugte Strukturen gemäß Formel (I) gilt Folgendes:
- R: ist bei jedem Auftreten gleich oder verschieden eine geradkettige oder verzweigte Alkylenkette mit 2 bis 15 C-Atomen, die mit R¹ substituiert oder unsubstituiert sein kann, in der auch ein oder mehrere nicht benachbarte C-Atome durch -NR²-, -O- oder -S-, ersetzt sein können, ein bivalentes aromatisches oder heteroaromatisches Ringsystem, ausgewählt aus Thiophen, Benzothiophen, Benzol, Biphenyl, Naphthalin, Anthracen, Pyren oder Phenanthren, welches unsubstituiert oder mit ein oder zwei Substituenten R¹ substituiert ist, ein 9,9'-substituiertes Fluoren, ein unsubstituiertes oder mit bis zu vier Substituenten R¹ substituiertes Spirobifluoren, ein 9,10- oder 9,9,10,10-substituiertes Dihydrophenanthren, ein Stilbenyl- oder Tolanylsystem, welches an den freien Positionen 0 bis 2 Substituenten R¹ trägt, oder Kombinationen aus 2 bis 4 dieser Systeme;
- R¹, R²: sind analog den oben gemachten Angaben;
- n: ist bei jedem Auftreten gleich oder verschieden 0, 1 oder 2;
die Verknüpfung mit POLY1 erfolgt besonders bevorzugt über die 3,6- oder die 2,7-Position, die 3,3'-Position, sofern R ein Aryl-, Heteroaryl-, Stilbenyl- oder Tolanylsystem ist oder über die Gruppe R oder R¹, sofern R bzw. R¹ eine aromatische oder heteroaromatische Einheit oder eine Stilbenyl- oder Tolanyleinheit ist, so dass die Anzahl der aromatischen Atome zwischen den Verknüpfungspunkten ein Vielfaches von vier beträgt.

Besonders bevorzugte Strukturelemente gemäß Formel (I) sind substituierte oder unsubstituierte Strukturen gemäß den abgebildeten Formeln (III) bis (XXXVIII), wobei die Einfachbindungen die Verknüpfung im Polymer andeuten. Sie sollen hier keine Methylgruppen darstellen. Potenzielle Substituenten sind wegen der besseren Übersichtlichkeit i. d. R. nicht abgebildet.

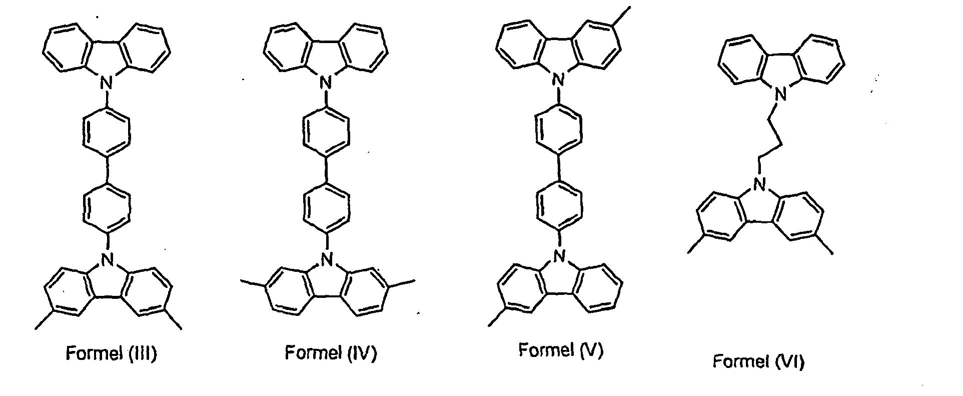

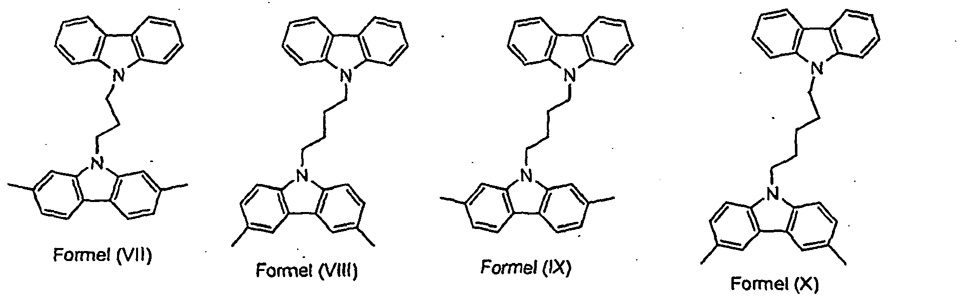

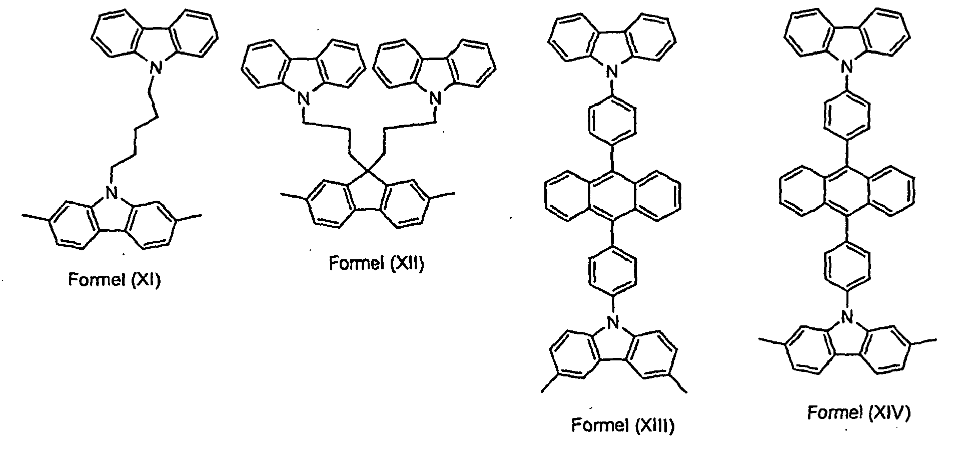

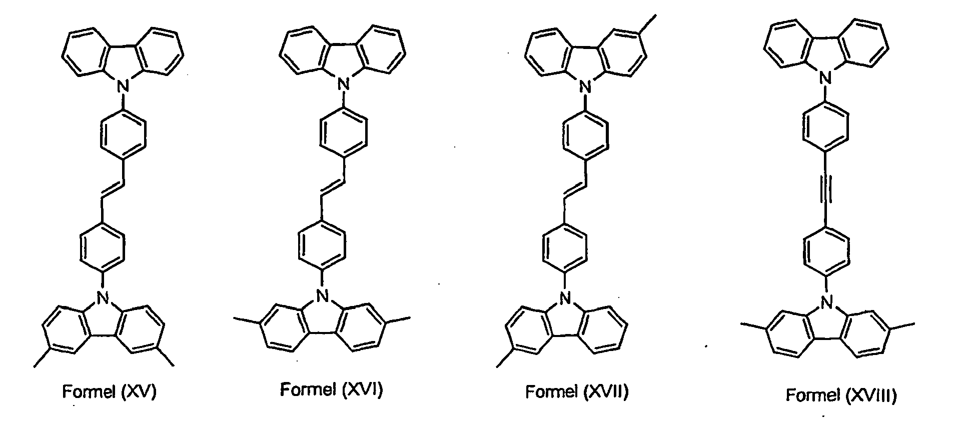

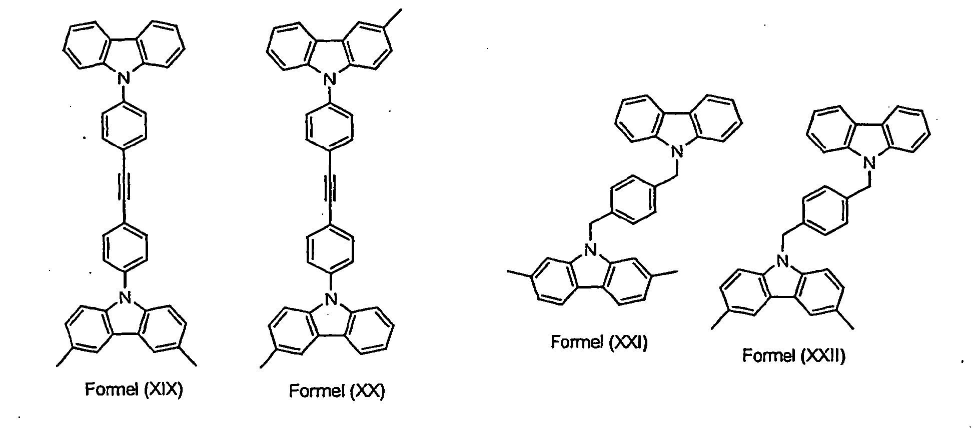

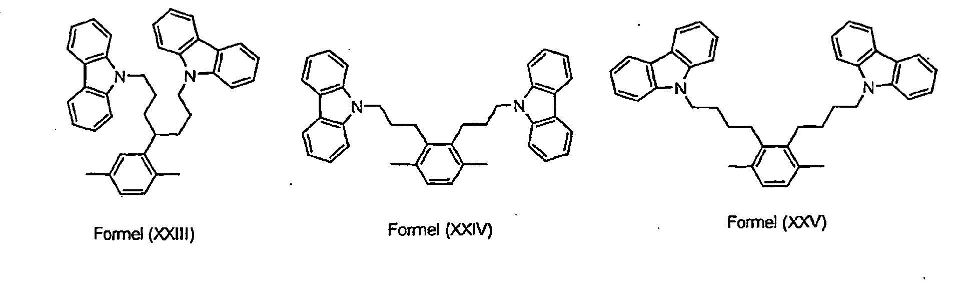

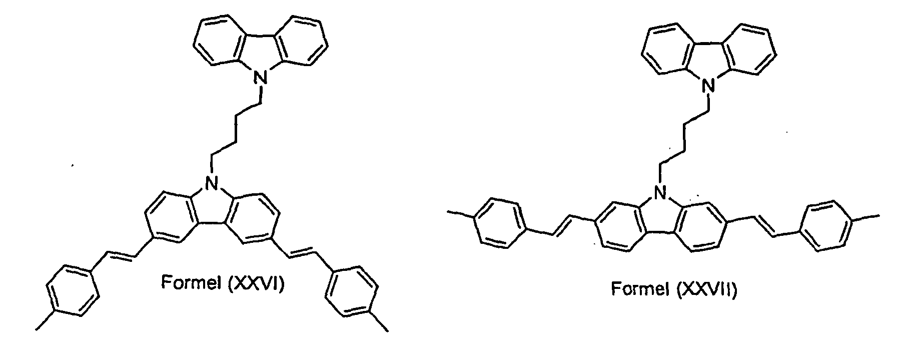

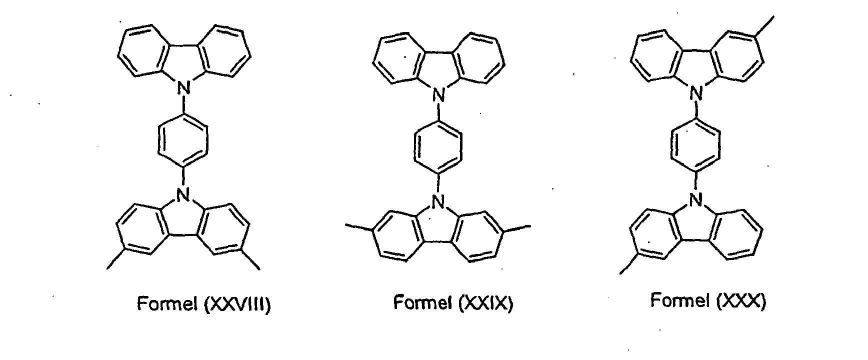

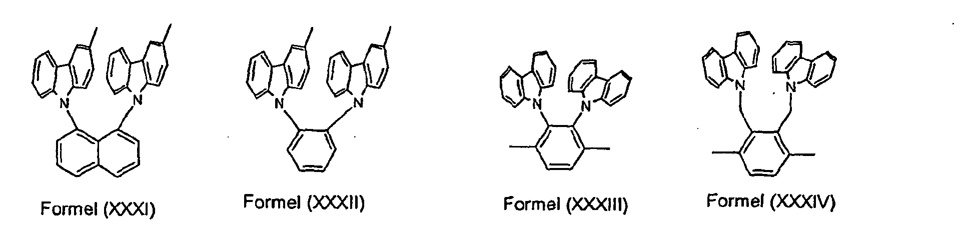

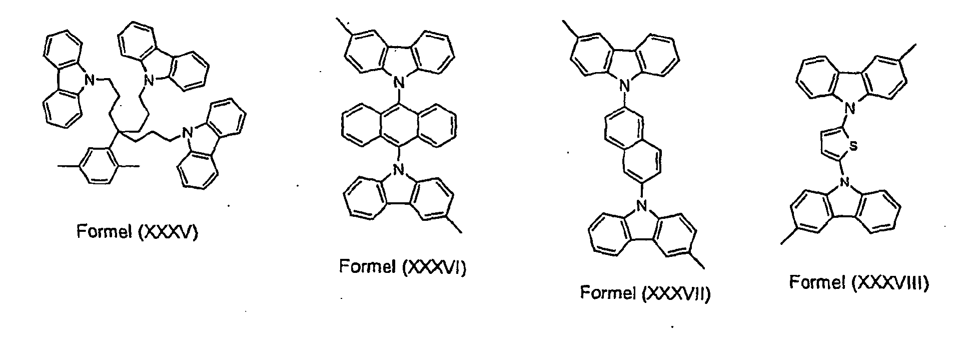

Für ganz besonders bevorzugte Strukturen gemäß Formel (I) gilt Folgendes:
- R: ist bei jedem Auftreten gleich oder verschieden eine geradkettige oder verzweigte Alkylenkette mit 3 bis 10 C-Atomen, die unsubstituiert oder mit R¹ substituiert sein kann, in der auch ein oder mehrere nicht benachbarte C-Atome durch -NR²-, -O- oder -S- ersetzt sein können, ein bivalentes aromatisches oder heteroaromatisches Ringsystem, ausgewählt aus Thiophen, Benzol, Biphenyl, Naphthalin, Anthracen oder Phenanthren, welches unsubstituiert oder mit ein oder zwei Substituenten R¹ substituiert ist, ein 9,9'-substituiertes Fluoren, ein mit 0 bis 4 Substituenten R¹ substituiertes Spirobifluoren, ein 9,10- oder 9,9,10,10-substituiertes Dihydrophenanthren oder ein Stilbenyl- oder Tolanylsystem, welches an den freien Positionen 0 bis 2 Substituenten R¹ trägt, oder Kombinationen aus 2 bis 3 dieser Systeme;
- R¹, R², n: sind analog den oben gemachten Angaben;
die Verknüpfung in POLY1 erfolgt analog den oben gemachten Angaben.

Für bevorzugte Strukturen gemäß Formel (II) gilt Folgendes:
- R: ist bei jedem Auftreten gleich oder verschieden eine geradkettige, verzweigte oder cyclische Alkylenkette mit 2 bis 20 C-Atomen, die mit R¹ substituiert oder unsubstituiert sein kann, in der auch ein oder mehrere nicht benachbarte C-Atome durch -NR²-, -O-, -S-, -CO-, -CO-O-, -CO-NR²-, -O-CO-O ersetzt sein können, ein bivalentes aromatisches oder heteroaromatisches Ringsystem, ausgewählt aus Thiophen, Benzothiophen, Benzol, Biphenyl, Pyridin, Chinoxalin, Fluoren, Spirobifluoren, Naphthalin, Anthracen, Pyren, Phenanthren, Dihydrophenanthren, welches an den freien Positionen 0 bis 4 Substituenten R¹ trägt, ein Stilbenyl- oder Tolanylsystem, welches an den freien Positionen 0 bis 4 Substituenten R¹ trägt, oder Kombinationen aus 2 bis 5 dieser Systeme;
- R¹, R², n: sind analog den oben gemachten Angaben.

Für besonders bevorzugte Strukturen gemäß Formel (II) gilt:
- R: ist bei jedem Auftreten gleich oder verschieden eine geradkettige oder verzweigte Alkylenkette mit 2 bis 15 C-Atomen, die mit R¹ substituiert oder unsubstituiert sein kann, in der auch ein oder mehrere nicht benachbarte C-Atome durch -NR²-, -O- oder -S-, ersetzt sein können, ein bivalentes aromatisches oder heteroaromatisches Ringsystem, ausgewählt aus Thiophen, Benzothiophen, Benzol, Biphenyl, Pyridin, Naphthalin, Anthracen, Pyren oder Phenanthren, welches unsubstituiert oder mit ein oder zwei Substituenten R¹ substituiert ist, ein 9,9'-substituiertes Fluoren, ein unsubstituiertes oder mit bis zu vier Substituenten R¹ substituiertes Spirobifluoren, ein 9,10- oder 9,9,10,10-substituiertes Dihydrophenanthren, ein Stilbenyl- oder Tolanylsystem, welches an den freien Positionen 0 bis 2 Substituenten R¹ trägt, oder Kombinationen aus 2 bis 4 dieser Systeme;
- R¹, R²: sind analog den oben gemachten Angaben;
- n: ist bei jedem Auftreten gleich oder verschieden 0, 1 oder 2.

Besonders bevorzugte Strukturelemente gemäß Formel (II) sind substituierte oder unsubstituierte Strukturen gemäß den abgebildeten Formeln (XXXIX) bis (LVIII). Potenzielle Substituenten sind wegen der besseren Übersichtlichkeit i. d. R. nicht abgebildet.

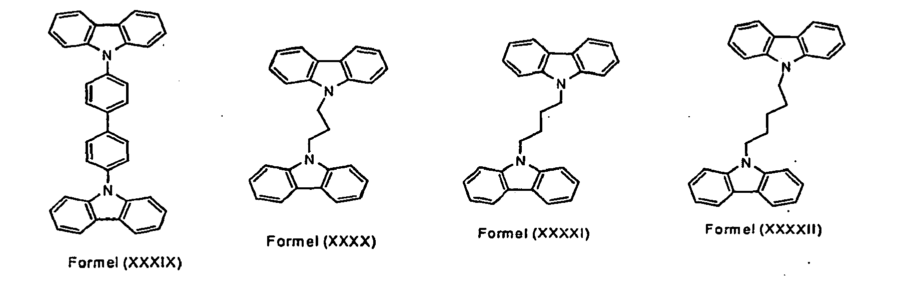

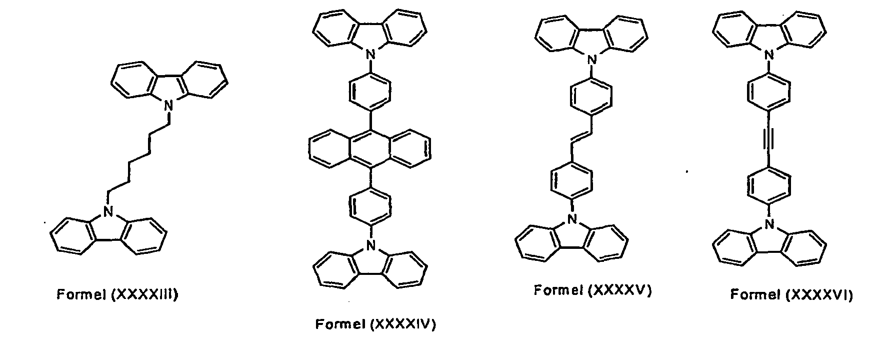

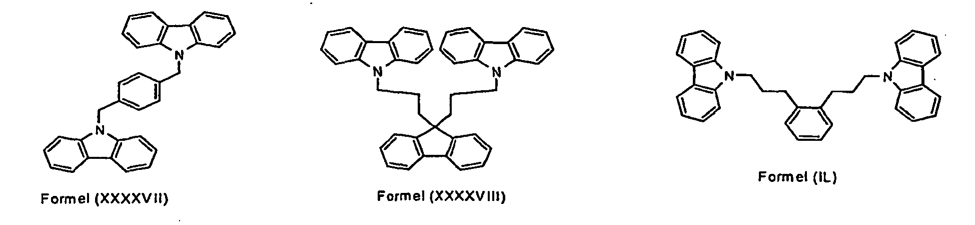

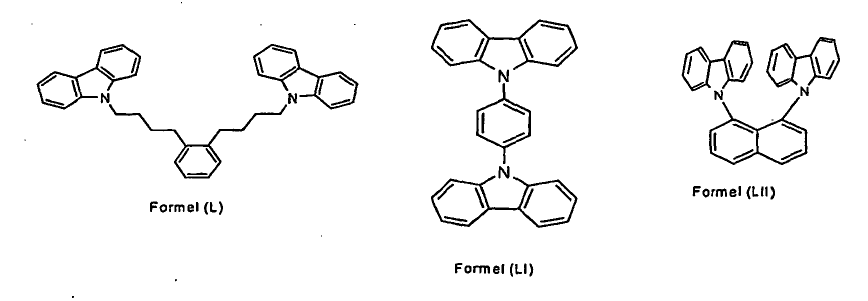

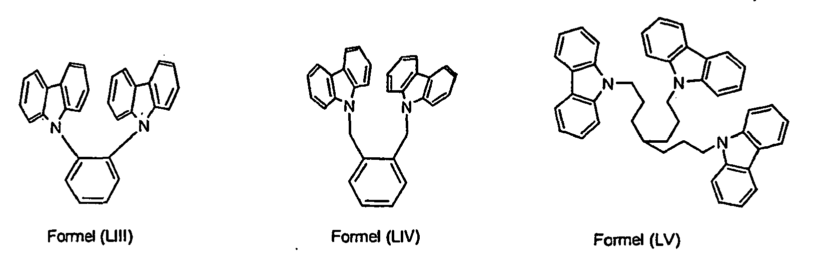

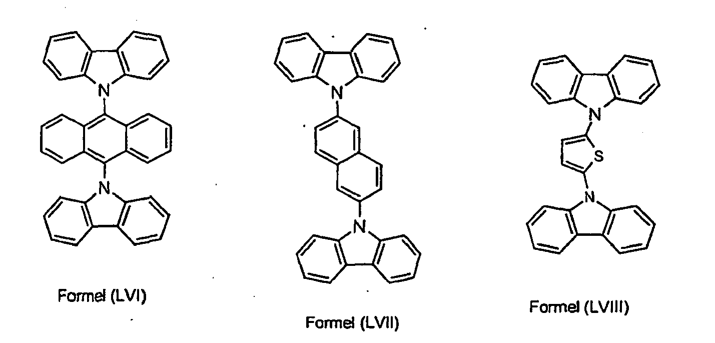

Für ganz besonders bevorzugte Strukturen gemäß Formel (II) gilt Folgendes:
- R: ist bei jedem Auftreten gleich oder verschieden eine geradkettige oder verzweigte Alkylenkette mit 3 bis 10 C-Atomen, die unsubstituiert oder mit R¹ substituiert sein kann, in der auch ein oder mehrere nicht benachbarte C-Atome durch -NR²-, -O- oder -S- ersetzt sein können, ein bivalentes aromatisches oder heteroaromatisches Ringsystem, ausgewählt aus Thiophen, Benzol, Biphenyl, Naphthalin, Anthracen oder Phenanthren, welches unsubstituiert oder mit ein oder zwei Substituenten R¹ substituiert ist, ein 9,9'-substituiertes Fluoren, ein mit 0 bis 4 Substituenten substituiertes Spirobifluoren, ein 9,10- oder 9,9,10,10-substituiertes Dihydrophenanthren oder ein Stilbenyl- oder Tolanylsystem, welches an den freien Positionen 0 bis 2 Substituenten R¹ trägt oder Kombinationen aus 2 bis 3 dieser Systeme;
- R¹, R², n: sind analog den oben gemachten Angaben.

Auch wenn dies aus der Beschreibung hervorgeht, sei hier nochmals explizit darauf verwiesen, dass sowohl die Struktureinheiten gemäß Formel (I) und (II), als auch jene gemäß den Formeln (III) bis (LVIII) unsymmetrisch substituiert sein können, d. h. dass an einer Einheit unterschiedliche Substituenten R¹ vorhanden sein können, bzw. diese auch an unterschiedliche Positionen gebunden sein können.

Struktureinheiten gemäß Formel (II), die in BLEND2 bis BLEND4 verwendet werden, können beispielsweise wie im Folgenden beschrieben erhalten werden:
- Die N-Alkylierung oder N-Benzylierung von Carbazolen ist in der Literatur bekannt. Auf diese Weise können auch zwei Carbazoleinheiten mit einer substituierten oder unsubstituierten Alkylen-, Benzyl-, Alkylarylen- oder Cycloalkylenkette überbrückt werden. Die Synthese erfolgt durch Reaktion des Carbazols mit einem Alkylierungsmittel unter basischen Bedingungen, wie beispielsweise beschrieben in: M. E. Wright et al., J. Org. Chem. 1989, 54, 965.
- Die N-Arylierung des Carbazols kann gemäß HARTWIG-BUCHWALD erfolgen und wird für Carbazol beispielsweise beschrieben in: M. Watanabe et al., Tetrahedron Lett. 2000, 41, 481. Ebenso können mit dieser Methode zwei Carbazoleinheiten durch entsprechende Arylen-, Heteroarylen-, Stilbenylen- oder Tolanylengruppen überbrückt werden.
- Die Synthese von Carbazolen, die am Carbazolgrundkörper Alkylsubstituenten tragen, ist in der Literatur bekannt: P. Bhattacharyya et al., J. Chem. Soc., Chem. Commun. 1984, 1668.
- Weitere Substitutionen am Carbazolgrundkörper können ausgehend von den unten beschriebenen Halogen-Verbindungen erhalten werden. Dadurch können, beispielsweise durch Palladium-katalysierte Kreuzkupplungsreaktionen, weitere organische Reste eingeführt werden. Ebenso können durch analoge Reaktionen mit entsprechend substituierten Triplett-Emittern Verbindungen aus Carbazol-Dimeren und Triplett-Emittern (VERB3) erhalten werden, wie sie für BLEND4 benötigt werden.

Für die Synthese von POLY1 können die entsprechenden Monomere, die im Polymer zu Struktureinheiten gemäß Formel (I) führen, beispielsweise wie im Folgenden beschrieben erhalten werden:
- Die Synthese von 3,6-Dibromcarbazol erfolgt durch Bromierung des Carbazols, wie in der Literatur beschrieben: Smith et al., Tetrahedron 1992, 48, 7479.
- Die Synthese von 2,7-Dibromcarbazol erfolgt durch Aufbau des Carbazolgrundkörpers, wie in der Literatur beschrieben: Tidwell et al., Eur. J. Med. Chem. 1997, 32, 781.
- Eine entsprechende Funktionalisierung, die eine Verwendung als Monomer ermöglicht (also z. B. Einführung von Halogen-Endgruppen), kann prinzipiell entweder an den Vorstufen erfolgen oder als letzter Schritt an dem bereits vollständig aufgebauten Grundgerüst.
- Vorab können die Funktionalitäten bereits vorhanden sein, wenn diese bei folgenden Reaktionsschritten entweder nicht oder sehr erschwert reagieren. Dies kann z. B. der Fall sein bei einfacher Substitutionsreaktion, oder wenn man unterschiedliche Reaktivitäten (z. B. Iod gegenüber Brom, bzw. Brom gegenüber Chlor) ausnutzen kann.
- Andererseits kann es auch vorteilhaft sein (bei z. B. vorliegender Substitution bzw. dirigierenden Resten), zunächst den überbrückten Carbazolgrundkörper aufzubauen und in einem letzten Schritt die Halogenfunktionalität einzuführen. So ist es beispielsweise möglich, in die 3- und 6-Positionen einer Carbazoleinheit Brom einzuführen (beispielsweise durch milde NBS-Bromierung, z. B. Creason et al., J. Org. Chem. 1972, 37, 4440), wenn die zweite Carbazoleinheit durch Substituenten blockiert ist. Wie oben geschildert, kann dieses Verfahren bei Vorhandensein (i) entsprechender blockierender Substituenten, (ii) entsprechend dirigierender Reste oder (iii) aktivierter bzw. desaktivierter Heterocyclen auch für weitere Strukturen gemäß Formel (I) angewendet werden. Ebenso ist eine Funktionalisierung in 6,6'-Position möglich, wenn die 3,3'-Positionen bereits durch andere Substituenten blockiert sind.
- Aus den Halogenderivaten können über Standardverfahren entsprechende Bisboronsäurederivate bzw. Bisstannanderivate (für die o. g. Polymerisationsverfahren der Typen A und C) hergestellt werden. Diese Verfahren bestehen i. d. R. darin, das vorhandene Halogen gegen ein Metall (z. B. Mg, Li) auszutauschen und dieses mit einer Borester- bzw. einer Trialkylzinnhalogenverbindung umzusetzen. Für die Herstellung von Boronsäurederivaten sind auch katalytische Verfahren zur direkten Umsetzung der Halogenide mit beispielsweise Boranen oder Diboranen unter Palladiumkatalyse bekannt.

Weiterhin Gegenstand der Erfindung sind bifunktionelle monomere Verbindungen gemäß Formel (LIX), 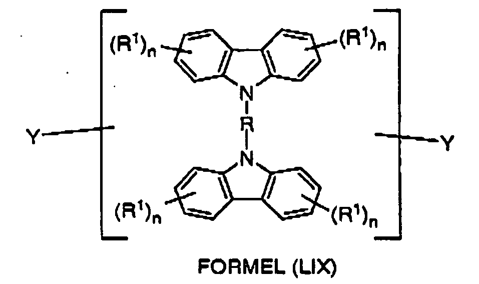 dadurch gekennzeichnet, dass die beiden funktionellen Gruppen Y, gleich oder verschieden, unter Bedingungen der C-C- bzw. C-N-Verknüpfungen copolymerisieren; die und für die weiteren Symbole und Indizes gilt:
- R: ist bei jedem Auftreten gleich oder verschieden eine geradkettige, verzweigte oder cyclische Alkylenkette mit 1 bis 40 C-Atomen, die mit R¹ substituiert oder unsubstituiert sein kann, in der auch ein oder mehrere nicht benachbarte C-Atome durch -NR²-, -S-,-CO-, -CO-O-, -CO-NR²-, -O-CO-O- ersetzt sein können, ein bivalentes aromatisches oder heteroaromatisches Ringsystem mit 2 bis 40 C-Atomen, welches mit R¹ substituiert oder unsubstituiert sein kann, eine mit R¹ substituierte oder unsubstituierte Vinyleneinheit oder eine Kombination aus 2 bis 5 dieser Systeme; die aromatischen Einheiten können dabei auch Teil eines größeren kondensierten Systems bilden; die möglichen Substituenten R¹ können optional an jeder freien Position sitzen;
- R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -NR²-, -S-, -CO-O-, -O-CO-O- ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R¹ substituiert sein kann, eine Vinyl- oder Acetylengruppe oder F, Cl, Br, I, NO₂, CN, N(R²)₂, B(R²)₂, Si(R²)₂, wobei auch zwei oder mehrere Reste R¹ miteinander ein aliphatisches oder aromatisches, mono- oder polycyclisches Ringsystem bilden können;
- R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können und welche auch durch einen oder mehrere nicht-aromatische Reste R² substituiert sein kann; dabei können auch zwei oder mehrere Reste R² miteinander ein Ringsystem bilden;
- n: ist bei jedem Auftreten gleich oder verschieden 0, 1, 2, 3 oder 4, mit der Maßgabe, dass n nicht 4 sein darf, wenn eine Verknüpfung mit Y an dieser Phenyleinheit erfolgt, und dass n nicht 3 oder 4 sein darf, wenn beide Verknüpfungen mit Y an dieser Phenyleinheit erfolgen;
ausgenommen sind dabei die folgenden Verbindungen:

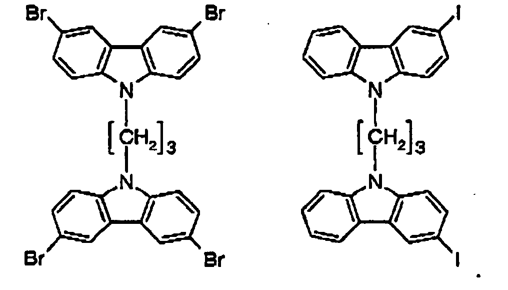

Bevorzugt ist Y ausgesucht aus den Gruppen Cl, Br, I, O-Tosylat, O-Triflat, OSO₂R², B(OH)₂, B(OR²)_{2,} Sn(R²)₃ und NHR², wobei R² dieselbe Bedeutung hat, wie oben beschrieben. Die C-C- bzw. C-N-Verknüpfungen sind dabei bevorzugt ausgewählt aus den Gruppen der SUZUKI-Kupplung, der YAMAMOTO-Kupplung, der STILLE-Kupplung und der HARTWIG-BUCHWALD-Kupplung. Insbesondere bevorzugt sind hier monomere Verbindungen gemäß Formel (LIX), die im Polymer zu Struktureinheiten gemäß Formel (III) bis (XXXVIII) führen.

Die in BLEND1 und BLEND3 eingemischten Struktureinheiten VERB1, bzw. die in POLY2 (= BLEND2) einpolymerisierten Struktureinheiten VERB2, bzw. die in BLEND4 eingemischten Struktureinheiten VERB3 können aus beliebigen organischen oder metallorganischen Substanzklassen ausgewählt werden, die einen Transfer von so genannten Singulett-Excitonen zu Triplett-Excitonen ermöglichen und auch bei Raumtemperatur aus dem Triplett-Zustand Licht emittieren können: Dies sind zunächst vor allem Verbindungen, welche Schweratome, d. h. Atome aus dem Periodensystem der Elemente mit einer Ordnungszahl von mehr als 36, enthalten. Besonders geeignet sind hierfür Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Solche Verbindungen sind für alle Emissionsfarben (blau, grün, rot) bekannt.

VERB1 bzw. VERB3 kann eine niedermolekulare, oligomere, dendritische oder polymere Verbindung sein. Da VERB1 bwz. VERB3 als Blend (BLEND1, BLEND3, BLEND4) verarbeitet wird, muss eine ausreichende Löslichkeit in geeigneten Lösemitteln (z. B. Toluol, Xylol, Anisol, THF, Methylanisol, Methylnaphthalin oder Mischungen dieser Lösemittel) gegeben sein, damit die Verarbeitung aus Lösung in diesen Lösemitteln möglich ist. Als niedermolekulare Struktureinheiten kommen hier z. B. verschiedene Komplexe in Frage, welche beispielsweise in WO 02/068435, WO 02/081488, EP 1239526 und WO 04/026886 beschrieben sind. Als Dendrimer-Strukturen kommen hierfür Komplexe in Frage, wie beispielsweise in WO 99/21935, WO 01/059030 und WO 02/066552 beschrieben sind.

VERB2 wird kovalent in die Polymerkette von POLY2 (= BLEND2) eingebaut. Dabei kann sowohl ein Einbau in die Haupt- wie auch in die Seitenkette des Polymers bevorzugt sein. Um den Einbau von VERB2 in POLY2 zu ermöglichen, müssen an VERB2 funktionelle polymerisierbare Gruppen vorhanden sein. Beispiele für entsprechende bromierte Komplexe, die als Monomere in Polymerisationsreaktionen eingesetzt werden können, werden beschrieben in WO 02/068435.

Die erfindungsgemäße Mischung BLEND1 wird erhalten, indem dem Polymer POLY1 Einheiten VERB1 zugemischt werden. Die erfindungsgemäße Mischung BLEND2 wird erhalten, indem dem Polymer POLY2 Struktureinheiten gemäß Formel (II) zugemischt werden. Die erfindungsgemäße Mischung BLEND3 wird erhalten, indem dem Polymer POLY3 Struktureinheiten gemäß Formel (II) sowie Einheiten VERB1 zugemischt werden. Die erfindungsgemäße Mischung BLEND4 wird erhalten, indem dem Polymer POLY3 Einheiten VERB3 zugemischt werden.

Es kann auch bevorzugt sein, in BLEND1 bis BLEND4 noch weitere konjugierte, teilkonjugierte oder nicht-konjugierte Polymere, Oligomere, Dendrimere oder niedermolekulare Verbindungen einzumischen. So kann beispielsweise durch Zugabe einer elektronisch aktiven Substanz die Loch- bzw. Elektroneninjektion, der Loch- bzw. Elektronentransport oder das Ladungsgleichgewicht im entsprechenden Blend reguliert werden. Die Zusatzkomponente kann auch den Singulett-Triplett-Transfer verbessern. Jedoch auch die Zugabe elektronisch inerter Verbindungen kann hilfreich sein, um beispielsweise die Viskosität der Lösung oder die Morphologie des Films zu kontrollieren. Die so erhaltenen Blends sind also auch Gegenstand der Erfindung.

Weiterhin Gegenstand der Erfindung sind konjugierte Polymere POLY4, enthaltend
(A) 1 - 99.9 mol%, bevorzugt 10 - 99 mol%, besonders bevorzugt 20 - 99 mol% einer oder mehrerer Einheiten gemäß Formel (I), 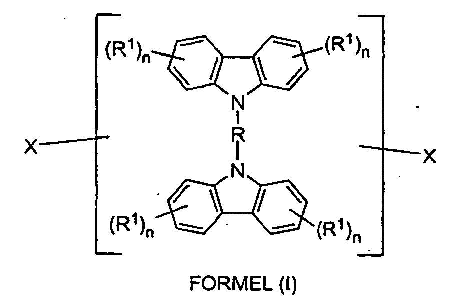 wobei die Symbole X, R, R¹, R² und die Indizes n dieselbe Bedeutung haben, wie oben beschrieben, und
(B) 0.1 - 95 mol%, bevorzugt 0.5 - 80 mol%, besonders bevorzugt 1 - 50 mol%, insbesondere 2 - 25 mol% eines oder mehrerer Triplett-Emitter, vorzugsweise in Form einer oder mehrerer metallorganischer Struktureinheiten VERB2.

Dabei erfolgt der Einbau der Struktureinheiten gemäß Formel (I) wie für das Polymer POLY1 beschrieben. Der Einbau der Struktureinheiten VERB2 erfolgt, wie für POLY2 bereits beschrieben, in die Haupt- und/oder Seitenkette von POLY4.

POLY4 kann weitere Strukturelemente (z. B. Polymer-Grundgerüst-Bausteine, Ladungsinjektions- oder -transportbausteine) enthalten, wie für POLY1 bis POLY3 beschrieben. Ebenso kann es statistisch, teilstatistisch, alternierend oder blockartig aufgebaut, kann linear, verzweigt oder dendritisch sein. Auch in POLY4 wird die Löslichkeit des Polymers vor allem durch die Substituenten R und R¹ an den Polymerbausteinen bestimmt. Die Synthese von POLY4 erfolgt wie für POLY1 bis POLY3 beschrieben. Besonders bevorzugte Struktureinheiten gemäß Formel (I) sind die oben abgebildeten Strukturen gemäß Formel (III) bis (XXXVIII).

Des Weiteren kann bevorzugt sein, in POLY4 noch weitere konjugierte, teilkonjugierte oder nicht-konjugierte Polymere, Oligomere, Dendrimere oder niedermolekulare Verbindungen einzumischen, so dass auch hier ein Blend entsteht. Hier kann es bevorzugt sein, Struktureinheiten gemäß Formel (II) einzumischen, so dass der Gesamtanteil an Strukturen gemäß Formel (I) und (II) erhöht wird. Ebenso kann das Einmischen von Struktureinheiten VERB1 bevorzugt sein. Aber auch die Zugabe anderer Komponenten kann sich für manche Anwendungen als sinnvoll erweisen. So kann beispielsweise durch Zugabe einer elektronisch aktiven Substanz die Loch- bzw. Elektroneninjektion, der Loch- bzw. Elektronentransport oder das Ladungsgleichgewicht des so entstandenen Blends reguliert werden. Die Zusatzkomponente kann auch den Singulett-Triplett-Transfer verbessern. Jedoch auch die Zugabe elektronisch inerter Verbindungen kann hilfreich sein, um beispielsweise die Viskosität der Lösung oder die Morphologie des Films zu kontrollieren. Die so aus POLY4 erhaltenen Blends sind also auch Gegenstand der Erfindung.

Die Darstellung von BLEND1 bis BLEND4 (bzw. gegebenenfalls von einem Blend aus POLY4 und weiteren Komponenten) erfolgt folgendermaßen: Die Einzelbestandteile des Blends werden in einem geeigneten Mischungsverhältnis zusammengegeben und in einem geeigneten Lösemittel gelöst. Geeignete Lösemittel sind beispielsweise Toluol, Anisol, Xylole, Methylanisol, Methylnaphthalin, Chlorbenzol, cyclische Ether (z. B. Dioxan, THF, Methyldioxan), Amide (z. B. NMP, DMF) und Mischungen dieser Lösemittel. Alternativ können die Bestandteile des Blends auch einzeln gelöst werden. Die Lösung des Blends erhält man in diesem Fall durch Zusammenfügen der Einzellösungen im geeigneten Mischungsverhältnis. Dabei findet der Lösevorgang bevorzugt in einer inerten Atmosphäre statt. Der Blend wird üblicherweise nicht als Feststoff (durch nochmaliges Ausfällen) isoliert, sondern direkt aus Lösung weiter verarbeitet.
Ein geeignetes Verhältnis der einzelnen Komponenten ist beispielsweise eine Mischung, die insgesamt 1 - 99.5 mol%, bevorzugt 10 - 99 mol%, besonders bevorzugt 20 - 99 mol% Einheiten gemäß Formel (I) und Formel (II) enthält und 0.1 - 95 mol%, bevorzugt 0.5 - 80 mol%, besonders bevorzugt 1 - 50 mol%, insbesondere 2 - 25 mol% VERB1, VERB2 und VERB3 enthält, unabhängig davon, ob die Komponenten kovalent an ein Polymer gebunden sind oder eingemischt sind.

Die erfindungsgemäßen Mischungen BLEND1 bis BLEND4 und Polymere POLY4 weisen gegenüber dem o. g. Stand der Technik u. a. folgende überraschenden Vorteile auf:
- Die Lichtemission des Triplett-Emitters ist in erfindungsgemäßen Polymeren POLY1 bzw. Blends BLEND1 bis BLEND4 überraschend deutlich effizienter als in vergleichbaren Polymeren und Blends, die keine Einheiten gemäß Formel (I) bzw. Formel (II) enthalten (vgl. Angaben in Tabelle 1).
- Der Strom bei gegebener Spannung ist bei vergleichbaren Polymeren oder vergleichbaren Blends bei der Verwendung in PLEDs höher, d. h. die Strom-Spannungskennlinie ist steiler, wenn sowohl ein konjugiertes Polymer als auch Struktureinheiten gemäß Formel (I) bzw. Formel (II) vorhanden sind (unabhängig davon, ob es sich um ein reines konjugiertes Polymer oder eine Mischung handelt). Dies bringt für die Anwendung - wie oben bereits ausgeführt - deutliche Vorteile, da somit das Ziel, effiziente Vollfarbdisplays mit geringem Energieverbrauch zu erzeugen, ermöglicht wird.
- Die Löslichkeit in organischen Lösemitteln ist gut, d. h. in Lösemitteln, wie beispielsweise Toluol, Xylol, Anisol, Methylanisol oder Methylnaphthalin, sind die Mischungen BLEND1 bis BLEND4 bzw. die Polymere POLY4 in Konzentrationen im Bereich von mindestens 1 bis 30 g/L (je nach verwendetem Triplett-Emitter und Molekulargewicht des Polymers) löslich.

Die Mischungen BLEND1 bis BLEND4 bzw. die Polymere POLY4 können in PLEDs verwendet werden. Für den Bau von PLEDs wird in der Regel ein allgemeines Verfahren verwendet, das entsprechend für den Einzelfall anzupassen ist. Ein solches Verfahren wurde beispielsweise in DE 10249723.0 ausführlich beschrieben.

Wie oben beschrieben, eignen sich die erfindungsgemäßen Mischungen BLEND1 bis BLEND4 bzw. die erfindungsgemäßen Polymere POLY4 ganz besonders als Elektrolumineszenzmaterialien in derart hergestellten OLEDs oder Displays. Als Elektrolumineszenzmaterialien im Sinne dieser Erfindung gelten Materialien, die als aktive Schicht in einer OLED bei Anlegen eines elektrischen Feldes Licht abstrahlen (lichtemittierende Schicht).

Gegenstand der Erfindung ist daher auch die Verwendung einer erfindungsgemäßen Mischung BLEND1 bis BLEND4 bzw. eines erfindungsgemäßen Polymers POLY4 in einer OLED als Elektrolumineszenzmaterial.

Gegenstand der Erfindung ist ebenfalls eine OLED mit einer oder mehreren aktiven Schichten, wobei mindestens eine dieser Schichten eine oder mehrere erfindungsgemäße Mischungen BLEND1 bis BLEND4 bzw. erfindungsgemäße Polymere POLY4 enthält.

Im vorliegenden Anmeldetext und auch in den im Weiteren folgenden Beispielen wird auf die Verwendung erfindungsgemäßer Mischungen BLEND1 bis BLEND4 bzw. erfindungsgemäßer Polymere POLY4 in Bezug auf OLEDs und die entsprechenden Displays abgezielt. Trotz dieser Beschränkung der Beschreibung ist es für den Fachmann ohne weiteres erfinderisches Zutun möglich, die erfindungsgemäßen Polymere oder Blends auch für weitere Verwendungen in anderen elektronischen Devices (Vorrichtungen) zu benutzen, z. B. für organische Solarzellen (O-SCs), nicht-lineare Optik, organische optische Detektoren oder auch organische Laserdioden (O-Laser), um nur einige Anwendungen zu nennen. Diese sind ebenfalls Gegenstand der vorliegenden Erfindung.

Die Erfindung wird durch die nachfolgenden Beispiele näher erläutert, ohne sie dadurch einschränken zu wollen.

### Beispiele:

### Teil A: Synthese der Monomere und Blendbestandteile

### Beispiel A1: Synthese der Monomere für POLY1

Die Synthese der Monomere M1 bis M23 ist bereits in WO 02/077060 und der darin zitierten Literatur ausführlich beschrieben worden. Die Monomere sind zur besseren Übersicht im Folgenden nochmals dargestellt:

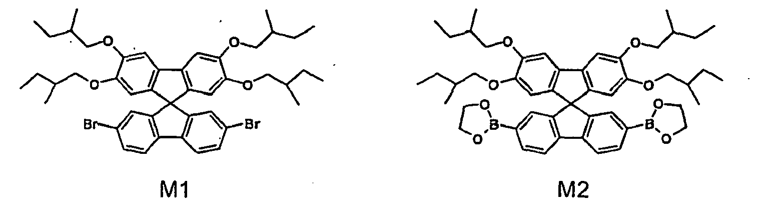

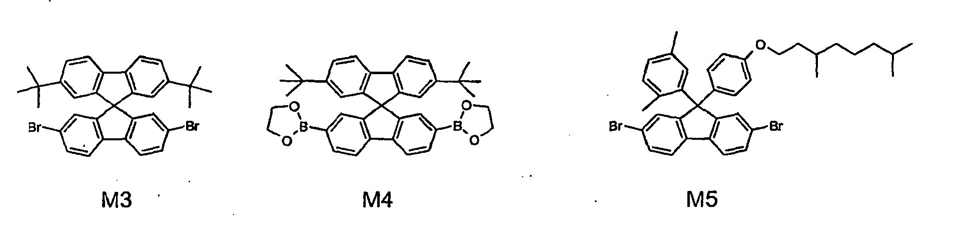

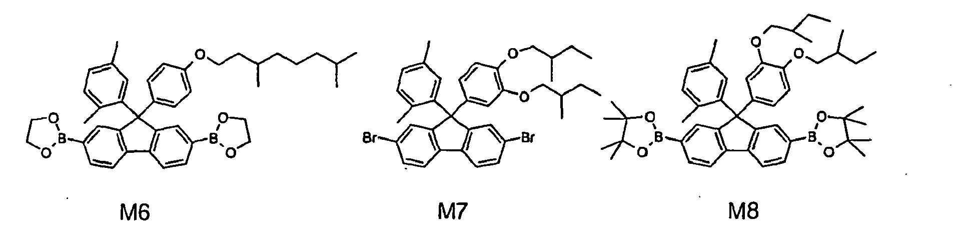

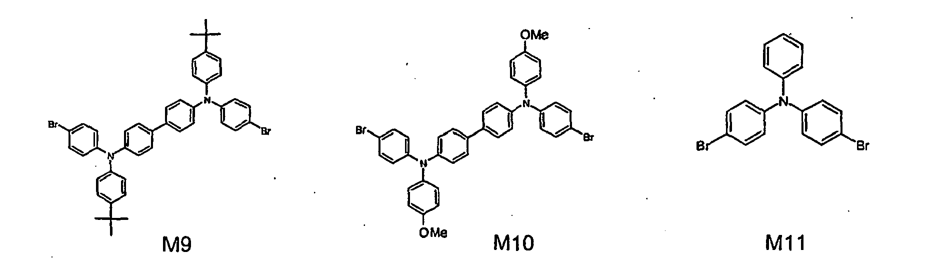

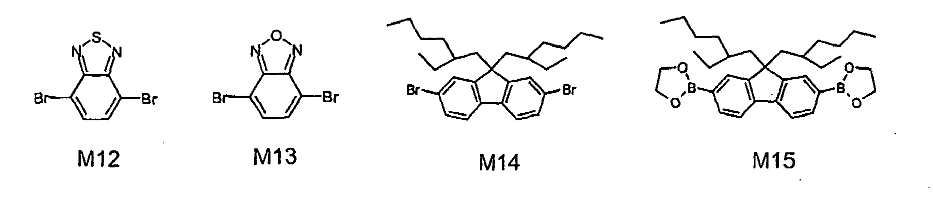

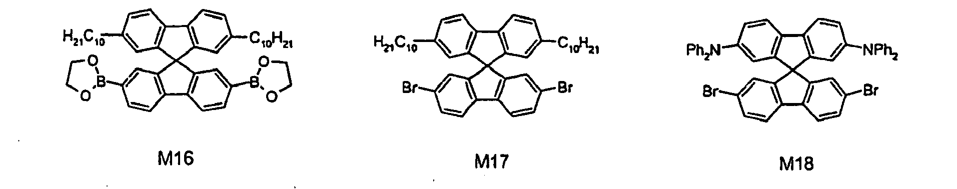

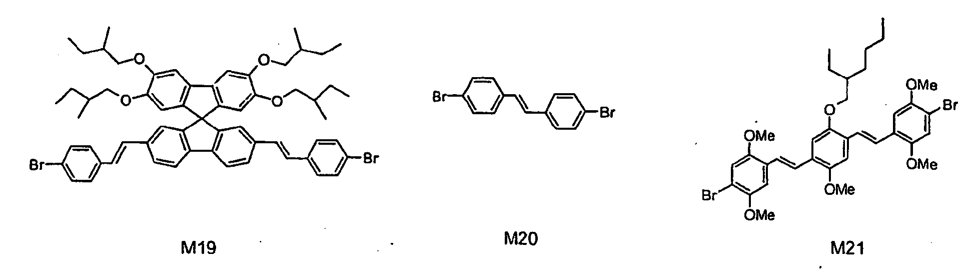

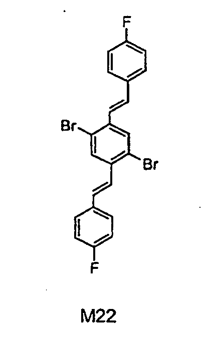

### Beispiel A2: Erfindungsgemäße Monomere gemäß Formel (I)

Die Monomere gemäß Formel (I) werden im Folgenden als "EM" (= erfindungsgemäßes Monomer) bezeichnet.
3,6-Dibromcarbazol wurde gemäß Smith et al., Tetrahedron 1992, 48, 7479 synthetisiert. Die Synthese von 3-Methylcarbazol erfolgte gemäß P. Bhattacharyya et al., J. Chem. Soc., Chem. Commun. 1984, 1668. Die strukturelle Integrität aller Produkte wurde mittels ¹H-NMR-Spektroskopie bewiesen, die Reinheit der Produkte wurde mittels HPLC bestimmt.

### N-(ω-Bromalkyl)carbazol: Allgemeine Beschreibung

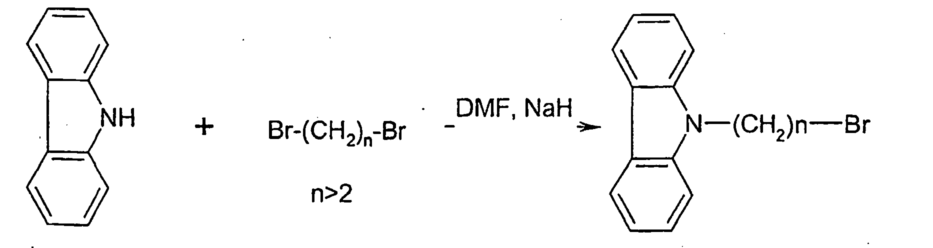

Unter Schutzgas werden 44 mmol Natriumhydrid zu einer Suspension von 40 mmol Carbazol in 100 mL trockenem THF gegeben. Nachdem die Wasserstoffentwicklung abgeschlossen ist, werden 400 mmol des entsprechenden α,ω-Dibromalkans durch ein Septum zugegeben und unter Ausschluss von Feuchtigkeit über Nacht bei RT gerührt. Das entstehende Natriumbromid wird abfiltriert, THF im Vakuum entfernt und überschüssiges Dibromalkan im Ölpumpen-Vakuum zurückgewonnen. Das Produkt wird durch Säulenchromatographie (Silicagel / CHCl₃) isoliert.

**N-(3-Brompropyl)carbazol (n = 3):** 6.68 g (40 mmol) Carbazol, 80.8 g (40.6 mL, 400 mmol) 1,3-Dibrompropan, 1.06 g (44 mmol) NaH, 100 mL THF.
Ausbeute: 9.2 g (56%), HPLC-Reinheit 99.4 %.
¹H-NMR (CDCl₃, 500 MHz): 8.11 (d, J = 8.7 Hz, 2H), 7.48 (m, 4H), 7.24 (m, 2H), 4.51 (t, J = 6.35 Hz, 2H), 3.39 (t, J = 6.35 Hz, 2H), 2.43 (m, 2H).

**N-(4-Brombutyl)carbazol (n = 4):** 6.68 g (40 mmol) Carbazol, 86.36 g (47.2 mL, 400 mmol) 1,4-Dibrombutan, 1.06 g (44 mmol) NaH, 100 mL THF.
Ausbeute: 8.58 g (71 %), HPLC-Reinheit 99.5 %.
¹H-NMR (CDCl₃, 500 MHz): 8.11 (d, J = 8.7 Hz, 2H), 7.48 (m, 4H), 7.24 (m, 2H), 4.35 (t, J = 6.35 Hz, 2H), 3.37 (t, J = 6.35 Hz, 2H), 2.43-1.81 (m, 4H).

### Monomere aus Alkylcarbazoldimeren: Allgemeine Beschreibung

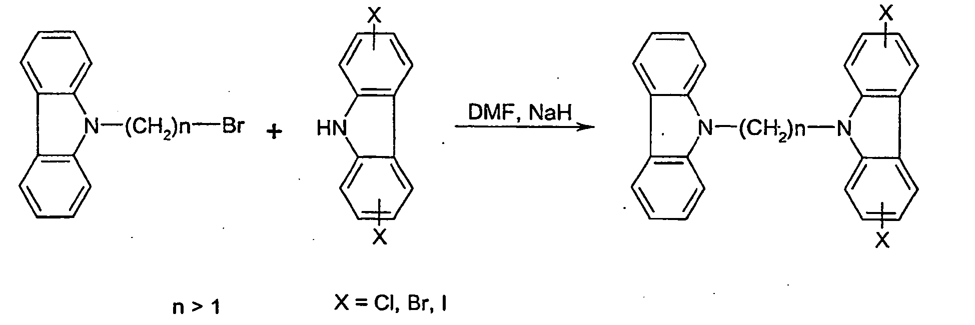

In einem 500 mL-Kolben mit Rückflusskühler werden unter Schutzgas 990 mg (41.2 mmol) Natriumhydrid in 80 mL trockenem DMF suspendiert. Zu dieser Reaktionsmischung wird eine Lösung aus 30.8 mmol 3,6- oder 2,7-Dihalogencarbazol (X = Cl, Br, I) in 80 mL DMF innerhalb 20 min bei RT zugetropft. Anschließend wird eine Lösung aus 30.8 mmol N-(ω-Bromalkyl)carbazol in 50 mL trockenem DMF zugetropft und 8 h auf 60 °C erhitzt. Nach Abkühlen auf Raumtemperatur werden vorsichtig 300 mL Wasser und 200 mL Ethylacetat zugesetzt. Die Phasen werden getrennt, die organische Phase mit 4 x 50 mL H₂O gewaschen, über MgSO₄ getrocknet und die Lösungsmittel in Vakuum entfernt. Das reine Produkt erhält man durch wiederholte Umkristallisation aus n-Hexan.

**EM1: 3,6-Dibrom-N-(N-carbazolyl)propyl)carbazol (X = Br, n = 3):** 10.0 g (30.8 mmol) 3,6-Dibromcarbazol, 8.9 g (30.8 mmol) N-(3-brompropyl)carbazol, 0.99 g (41.2 mmol) NaH, 160 mL DMF.
Ausbeute: 13.8 g (85 %), HPLC-Reinheit 99.9 %.
¹H-NMR (CDCl₃, 500 MHz): 8.12 (m, 4H), 7.45 (d, J = 8.7 Hz, 2H), 7.44-7.39 (m, 2H), 7.28-7.20 (d, J = 8.7 Hz, 4H), 6.77 (d, J = 8.7 Hz, 2H), 4.38 (t, J = 7.0 Hz, 2H), 3.23 (t, J = 7.36 Hz, 2H), 2.43 (m, 2H).

**EM2: 3,6-Dibrom-N-(N-carbazolyl)butyl)carbazol (X = Br, n = 4):** 10 g (30.8 mmol) 3,6-Dibromcarbazol, 9.3 g (30.8 mmol) N-(4-Brombutyl)carbazol, 0.99 g (41.2 mmol) NaH, 160 mL DMF.
Ausbeute: 14.6 g (87 %), HPLC-Reinheit 99.9 %.
¹H-NMR (CDCl₃, 500 MHz): 8.11 (m, 4H), 7.44 (d, J = 8.7 Hz, 2H), 7.43-7.39 (m, 2H), 7.28-7.20 (d, J = 8.7 Hz, 4H), 6.77 (d, J = 8.7 Hz, 2H), 4.34 (t, J = 6.35 Hz, 2H), 3.36 (t, J = 6.35 Hz, 2H), 2.42-1.80 (m, 4H).

### Fluorencarbazoldimere

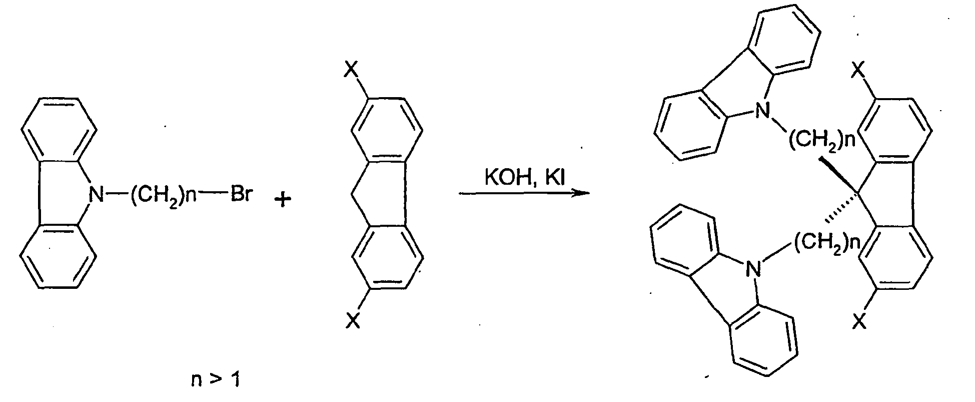

### EM3: 2,7-Dibrom-9,9-bis(3-(N-carbazolyl)propyl)fluoren (X = Br, n = 3):

Unter Schutzgas wurden 9.0 g (28 mmol) 2,7-Dibromfluoren, 16.4 g (57 mmol) N-(3-Brompropyl)carbazol und 0.5 g (3 mmol) KI in 56 mL DMSO bei RT gerührt, bis eine klare Lösung entstand. Anschließend wurden portionsweise 6.6 g (119 mmol) KOH zugegeben. Nach 1 h wurde die Mischung mit 200 mL Wasser versetzt und mit CHCl₃ extrahiert. Die vereinigten organischen Phasen wurden mit Wasser gewaschen und über MgSO₄ getrocknet. Anschließend wurde das Lösungsmittel im Vakuum entfernt, und das entstandene Öl wurde durch Säulenchromatographie (Silicagel, Hexan/EE 40 : 1) aufgereinigt.
Ausbeute: 15.5 g (76 %), HPLC-Reinheit: 99.5 %.
¹H-NMR (CDCl₃, 500 MHz): 8.10 (m, 4H), 7.88 (s, 2H), 7.61 (d, J = 7.9 Hz, 2H), 7.55 (d, J = 7.9 Hz, 2H), 7.44-7.38 (m, 4H), 7.28-7.17 (m, 8H), 4.30 (t, J = 7.02 Hz, 4H), 2.21 (t, J = 7.36 Hz, 4H), 1.91 (m, 4H).

### EM4: 2,7-Dibrom-9,9-bis(4-(N-carbazolyl)butyl)fluoren (X = Br, n = 4):

Die Synthese erfolgte in Analogie zur Synthese von EZ3. 9.0 g (28 mmol) 2,7-Dibromfluoren, 17.2 g (57 mmol) N-(4-Brombutyl)carbazol, 0.5 g (3 mmol) KI, 6.6 g (119 mmol) KOH, 56 mL DMSO.
Ausbeute: 15.4 g (73 %), HPLC-Reinheit 99.5 %.
¹H-NMR (CDCl₃, 500 MHz): 8.11 (m, 4H), 7.68 (s, 2H), 7.60 (d, J = 7.9 Hz, 2H), 7.43 (d, J = 7.9 Hz, 2H), 7.43-7.36 (m, 4H), 7.27-7.15 (m, 8H), 4.35 (t, J = 6.35 Hz, 4H), 2.23 (t, J = 6.35 Hz, 4H), 1.90-1.31 (m, 8H).

### Biphenylcarbazol

### 4,4'-Bis(3-methylcarbazol-9-yl)biphenyl

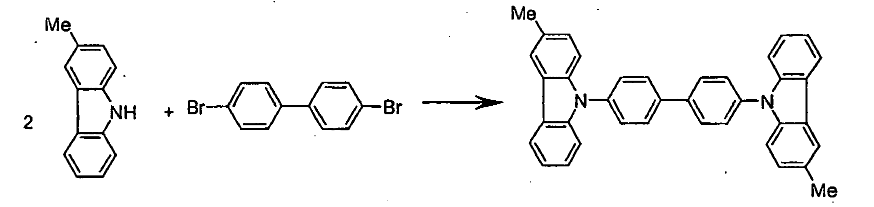

7.5 g (25 mmol) 4,4'-Dibrombiphenyl wurden in 95 mL p-Xylol vorgelegt, und die Lösung wurde 30 min. mit Argon entgast. Dann wurden zuerst 20.1 g (150 mmol) Kaliumphosphat, anschließend eine Lösung aus 0.27 g (1.5 mmol) Chlor-di*^{tert}*Butylphospin / 0.29 g (3 mmol) NaO*^{tert}*Bu / 5 mL p-Xylol und 10 Minuten später 0.11 g (0.5 mmol) Pd(II)acetat zugegeben. Nach Zugabe von 18.1 g (100 mmol) 3-Methylcarbazol wurde die Mischung 3 Tage bei 125 °C unter Rückfluss erhitzt. Die Mischung wurde mit 120 mL Wasser versetzt und einige Stunden gerührt. Der Feststoff wurde abgesaugt, mit Xylol und Wasser nachgewaschen und aus EtOH umkristallisiert.
Ausbeute: 21 g (95 %), HPLC-Reinheit 99.3 %.
¹H-NMR (CDCl₃, 500 MHz): 8.97 (d, J₄ = 2.0 Hz, 2H), 8.35 (dd, J₃= 9.2 Hz, J₄ = 2.0 Hz, 2H), 8.12 (d J₃ = 7.8 Hz, 2H), 7.55 (t,J₃ = 8.2 Hz, 2H), 7.49 (d, J₃ = 8.2 Hz, 2H), 7.46 (d, J₃ = 9.2 Hz, 2H), 7.40 (d, J₃ = 8.3 Hz, 4H), 7.35 (d, J₃ = 8.3 Hz, 4H), 7.34 (t, J₃ = 7.8 Hz, 2H), 2.35 (s, 3H)

### EM5: 4,4'-Bis(3-brom-6-methylcarbazol-9-yl)biphenyl

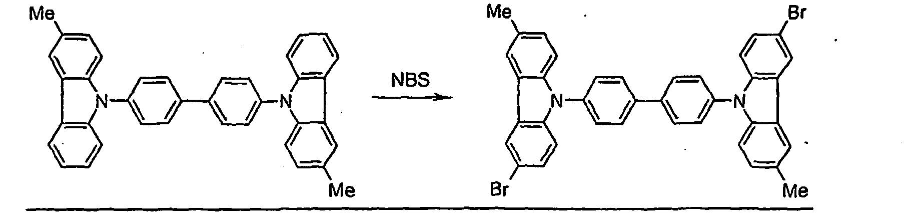

10.25 g (20 mmol) 4,4'-Bis(3-methylcarbazol-9-yl)biphenyl wurden in 30 mL trockenem Acetonitril gelöst. Unter Schutzgas wurden langsam 7.1 g (40 mmol) N-Bromsuccinimid hinzugegeben und 21 h bei RT gerührt. Der Rückstand wurde filtriert und mit etwas Acetonitril und anschließend mit heißem Wasser gewaschen. Das Produkt wurde durch Umkristallisation aus Dioxan gereinigt.
Ausbeute: 12 g (90 %), HPLC-Reinheit 99.3 %.
¹H-NMR (CDCl₃, 500 MHz): 8.99 (d, J₄ = 2.0 Hz, 2H), 8.40 (dd, J₃= 9.2 Hz, J₄ = 2.0 Hz, 2H), 8.22 (d J₃ = 7.8 Hz, 2H), 7.56 (t,J₃ = 8.2 Hz, 2H), 7.52 (d, J₃ = 8.2 Hz, 2H), 7.47 (d, J₃ = 9.2 Hz, 2H), 7.43 (d, J₃ = 8.3 Hz, 4H), 7.35 (t, J₃ = 7.8 Hz, 2H), 2.36 (s, 6H).

### Beispiele A3: Blendbestandteile gemäß Formel (II)

Die Blendbestandteile gemäß Formel (II) werden im Folgenden als CARB bezeichnet.

### CARB1: N-(N-Carbazolyl)propyl)-carbazol (n = 3):

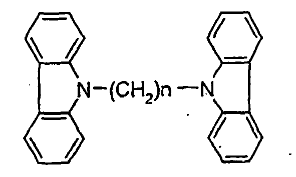

Unter Schutzgas wurden 0.99 g (41,2 mmol) Natriumhydrid zu einer Suspension aus 5.15 g (30.8 mmol) Carbazol in 160 mL trockenem THF gegeben. Nachdem die Wasserstoffentwicklung abgeschlossen war, wurden 3.11 g (15.4 mmol) 1,3-Dibrompropan durch ein Septum zugegeben und unter Ausschluss von Feuchtigkeit über Nacht bei RT gerührt. Das entstehende Natriumbromid wurde abfiltriert, THF im Vakuum entfernt und überschüssiges Dibrompropan im Ölpumpen-Vakuum zurückgewonnen. Das Produkt wurde durch Säulenchromatographie (Silicagel / CHCl₃) gereinigt.
Ausbeute: 5.4 g (94 %), HPLC-Reinheit 99.9 %.
¹H-NMR (CDCl₃, 500 MHz): 8.11 (m, 4H), 7.44-7.38 (m, 4H), 7.28-7.17 (m, 8H), 4.49 (t, J = 7.02 Hz, 4H), 2.22 (m, 2H).

### Beispiele A4: Struktureinheiten VERB1 zur Verwendung in Blends

Bei den hier beispielhaft verwendeten Verbindungen VERB1 handelt es sich um Derivate von Tris(phenylpyridyl)iridium(III). Die Synthese dieser Verbindungen ist bereits beschrieben in den Anmeldeschriften WO 02/081488 und WO 04/026886. Zur Übersicht sind die hier verwendeten Iridium-Komplexe im Folgenden nochmals aufgeführt:

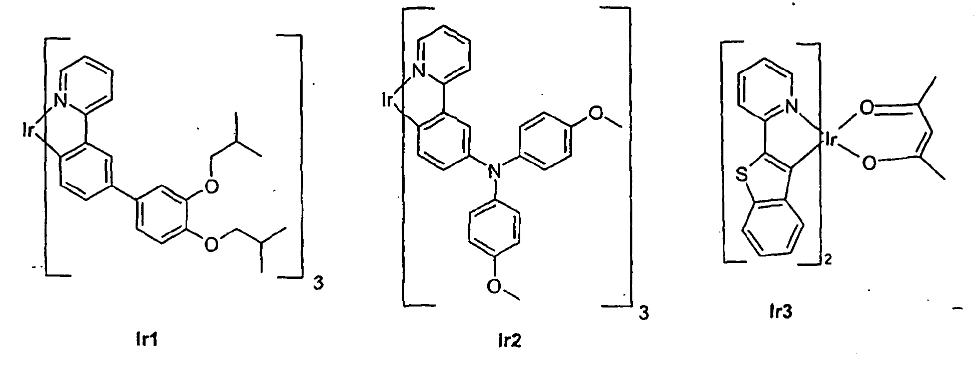

### Beispiele A5: Triplett-Comonomere VERB2

Bei den hier verwendeten Comonomeren VERB2 handelt es sich um Derivate von Tris(phenylpyridyl)iridium(III). Die Synthese dieser Verbindungen ist beispielsweise beschrieben in der nicht offen gelegten Anmeldung DE 10350606.3. Die hier verwendeten Iridium-Comonomere **Ir4** und **Ir5** sind zur Übersicht im Folgenden nochmals abgebildet:

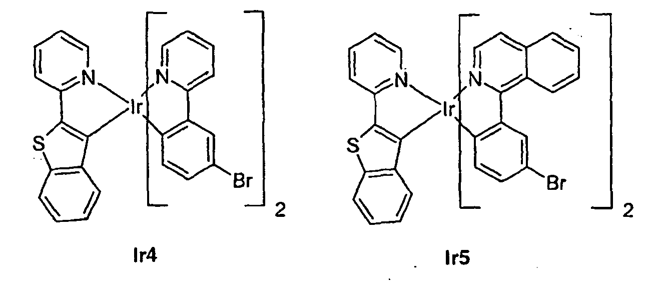

### Teil B: Herstellung der Polymere

Die Synthese konjugierter Polymere POLY3, die keine Einheiten gemäß Formel (I) und keine Verbindungen VERB2 enthalten, ist bereits beispielsweise in den Anmeldeschriften WO 02/077060 und WO 03/020790 beschrieben. Diese sind via Zitat Bestandteil der vorliegenden Anmeldung.

Im Folgenden ist beispielhaft die Synthese zweier Polymere des Typs POLY1 beschrieben, die Monomere gemäß Formel (I) enthalten.

### Beispiel B1: Synthese von Polymer P1

3.1706 g (4 mmol) Monomer M2, 1.9650 g (2.4 mmol) Monomer **M1**, 0.6069 g (0.8 mmol) Monomer M9, 0.4258 g (0.8 mmol) EM1 und 4.05 g Kaliumphosphat Hydrat wurden gelöst in 25 mL Dioxan, 25 mL Toluol und 7 mL H₂O (alle Lösungsmittel sauerstofffrei). Die Reaktionslösung wurde 30 Minuten bei 40 °C mit Argon entgast. Dann wurden 0.45 mg Pd(OAc)₂ und 3.65 mg P(o-tolyl)₃ als Katalysator zugegeben, und die Lösung wurde 4 h unter Rückfluss unter einer Argon-Atmosphäre erhitzt. Das Endcapping wurde mit 24 mg 3,4-Bispentoxy-benzolboronsäure in 20 mL Toluol durchgeführt und 1 h unter Rückfluss erhitzt. Dann wurden 40 mg 3,4-Bispentoxy-benzolbromid in 10 mL Toluol zugegeben und 3 h unter Rückfluss erhitzt. Nach Zugabe von weiteren 50 mL Toluol wurde die Polymerlösung bei 60 °C mit 100 mL 0.01 %iger wässriger NaCN-Lösung 3 h gerührt. Die Phasen wurden getrennt und die organische Phase mit 4 x 100 mL H₂O gewaschen. Das Polymer wurde durch Eintropfen in 300 mL Methanol ausgefällt und filtriert. Weitere Reinigung erfolgte durch Lösen in 300 mL THF bei 60 °C unter Argon, Filtration über Celit und erneute Ausfällung durch Zugabe von 600 mL Methanol. Das Polymer wurde filtriert und unter Vakuum getrocknet. Es wurden 4.73 g (93 % d. Th.) Polymer isoliert, M_{w} = 352,000 g/mol, Mn = 93,000 g/mol, Polydispersität = 3.8 (GPC in THF mit PS als Standard).

### Beispiel B2: Synthese von Polymer P2

3.1706 g (4 mmol) Monomer M2, 1.0825 g (1.6 mmol) Monomer **M7,** 1.7726 g (2.4 mmol) **EM3** und 4.05 g Kaliumphosphat Hydrat wurden gelöst in 37.5 mL Dioxan, 12.5 mL Toluol und 7 mL H₂O (alle Lösemittel sauerstofffrei). Die Reaktionslösung wurde 30 Minuten bei 40 °C mit Argon entgast. Dann wurden 0.45 mg Pd(OAc)₂ und 3.65 mg P(o-tolyl)₃ als Katalysator zugegeben, und die Lösung wurde 3 h unter Rückfluss unter einer Argon-Atmosphäre erhitzt. Die hochviskose Polymerlösung wurde mit 50 mL Toluol verdünnt. Dann wurde das Endcapping durchgeführt, indem 24 mg 3,4-Bispentoxy-benzolboronsäure in 20 mL Toluol zugegeben wurden, 1 h unter Rückfluss erhitzt, dann erfolgte Zugabe von 40 mg 3,4-Bispentoxy-benzolbromid in 30 mL Toluol und 1 h unter Rückfluss erhitzt. Die Polymerlösung wurde nochmals mit 50 mL Toluol verdünnt und bei 60 °C mit 100 mL 0.01 %iger wässriger NaCN-Lösung 3 h gerührt. Die Phasen wurden getrennt und die organische Phase mit 4 x 100 mL H₂O gewaschen. Das Polymer wurde durch Eintropfen in 400 mL Methanol ausgefällt und filtriert. Weitere Reinigung erfolgte durch Lösen in 350 mL THF bei 60 °C unter Argon, Filtration über Celit und erneute Ausfällung durch Zugabe von 700 mL Methanol. Das Polymer wurde filtriert und unter Vakuum getrocknet. Es wurden 4.69 g (90 % d. Th.) Polymer isoliert, M_{w} = 681,000 g/mol, Mₙ = 202,000 g/mol, Polydispersität = 3.4 (GPC in THF mit PS als Standard).

Weitere Polymere wurden analog den Beschreibungen für **P1** und **P2** dargestellt.

### Teil C: Herstellung der Blends

Die Herstellung der Blends erfolgte durch Lösen der Blendbestandteile im gewünschten Verhältnis und in der gewünschten Konzentration in einem geeigneten Lösemittel. Als Lösemittel wurde hier Toluol verwendet. Dabei wurde der Lösevorgang in einer inerten Atmosphäre bei 60 °C durchgeführt. Die Lösung wurde ohne Isolierung des Blends (nochmaliges Ausfällen der Feststoffanteile) direkt verarbeitet.

### Teil D: Herstellung und Charakterisierung von LEDs

Alle so erhaltenen Blends BLEND1 bis BLEND4 und Polymere POLY4 wurden auch für ' einen Einsatz in PLEDs untersucht. Die mit den Blends erhaltenen Resultate (Farbe, Effizienz, Betriebsspannung) sind in Tabelle 1 zusammengefasst (Beispiele D1 bis D6), ebenso wie Resultate, die mit Vergleichspolymeren und Blends erhalten wurden, die keine Einheiten gemäß Formel (I) bzw. Formel (II) enthalten (Beispiele V1 bis V4). Die mit den Polymeren POLY4 erhaltenen Resultate sind in Tabelle 2 zusammengefasst (Beispiele D7 und D8). Die Herstellung der PLEDs ist in DE 10249723.0 und der darin zitierten Literatur ausführlich beschreiben.

**Tabelle 1**

| | Zusammensetzung | | | | | | | Elektrolumineszenz | | | |
|---|---|---|---|---|---|---|---|---|---|---|---|
| Beispiel | Zusammensetzung POLY1 | | | | CARB1^{b} | VERB1^{b} | Sonstige^{b} | λₘₐₓ [nm] | Max. Eff. [cd/A] | U @ 100 cd/m² [V] | CIE x/y^{d} |
| | M1 ^{a} | M2^{a} | M9^{a} | EM^{a} | | | | | | | |
| Beispiel D1 | 30 | 50 | 10 | 10 EM1 | | Ir2 (8%) | | 605 nm | 9.28 cd/A | 7.71 V | 0.60 / 0.40 |
| Beispiel D2 | 30 | 50 | 10 | 10 EM1 | | Ir3 (8%) | | 620 nm | 4.35 cd/A | 4.42 V | 0.69/0.31 |
| Beispiel D3 | 30 | 50 | 10 | 10 EM1 | 20 | Ir2 (8%) | | 607 nm | 9.37 cd/A | 7.82 V | 0.61/0.39 |
| Beispiel D4 | 30 | 50 | 10 | 10 EM1 | 20 | Ir3 (8%) | | 620 nm | 4.96 cola | 4.16 V | 0.69/0.31 |
| Beispiel D5 | 30 | 50 | 10 | 10 EM1 | 40 | Ir2 (8%) | | 609 nm | 9.31 cd/A | 7.25 V | 0.61/0.39 |
| Beispiel D6 | 30 | 50 | 10 | 10 EM1 | 40 | Ir3 (8%) | | 620 nm | 5.38 cd/A | 3.83 V | 0.69/0.31 |
| | | | | | | | | | | | |
| Beispiel V1 (Vergleich) | | | | | | tr2(2%) | 18% CPB^{c}, 80% PVK^{c} | 600nm | 0.18 cd/A, | 6.70 V | 0.57/0.43 |
| Beispiel V2 (Vergleich) | 40 | 50 | 10 | | | Ir2 (5%) | | 605 nm | 0.40 cd/A | 6.52 V | 0.60/0.40 |
| Beispiel V3 (Vergleich) | | | | | | Ir3 (2%) | 18% CPB^{c}, 80% PVK^{c} | 620 nm | 1.06 cd/A | 9.91 V | 0.67/0.33 |
| Beispiel V4 (Vergleich) | 40 | 50 | 10 | | | Ir2 (8%) | | 609 nm | 0.32 cd/A | 8.78 V | 0.60/0.40 |

| | | | | | | | | | | | |
|---|---|---|---|---|---|---|---|---|---|---|---|
| a Anteile der verschiedenen Monomere im Polymer in mol%. b Art und Anteile der Blendbestandteile CARB und VERB1 und sonstiger Blendbestandteile an der Gesamtzusammensetzung der Mischung in Gew.%. c CPB = 2,2',7,7'-Tetra(N-carbazolyl)-9,9'-spirobifluoren, PVK = Poly(vinylcarbazol). d CIE-Koordinaten: Chromatizitäts-Koordinaten der Commission Internationale de l'Eclairage. | | | | | | | | | | | |

**Tabelle 2**

| | Zusammensetzung POLY4 | | | | | Elektrolumineszenz | | |
|---|---|---|---|---|---|---|---|---|
| Beispiel | M2 ^{a} | M7^{a} | M9^{a} | EM^{a} | Ir^{a} | Max. Eff. [cd/A] | U @ 100 cd/m² | CIE x/y^{b} |
| D7 | 50 | 25 | 10 | EM1 (10 mol%) | Ir4 (5 mol%) | 7.6 cd/A | 4.1 V | 0.61 / 0.39 |
| D8 | 50 | 29 | 10 | EM1 (10 mol%) | Ir5 (1 mol%) | 3.6 cd/A | 5.1 V | 0.68 / 0.32 |
| | | | | | | | | |

| | | | | | | | | |
|---|---|---|---|---|---|---|---|---|
| a Anteile der verschiedenen Monomere im Polymer in mol%. b CIE-Koordinaten: Chromatizitäts-Koordinaten der Commission Internationale de l'Eclairage. | | | | | | | | |

## Patentansprüche

1. Mischungen (Blends), enthaltend
(A) mindestens ein konjugiertes Polymer,
(B) mindestens eine überbrückte Carbazoleinheit der Formel (I), 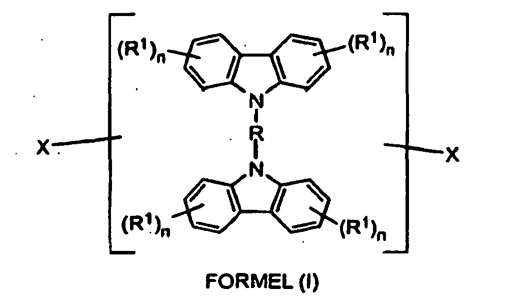 wobei die Symbole und Indizes folgende Bedeutung besitzen:
R ist bei jedem Auftreten gleich oder verschieden eine geradkettige, verzweigte oder cyclische Alkylenkette mit 1 bis 40 C-Atomen, die mit R¹ substituiert oder unsubstituiert sein kann, in der auch ein oder mehrere nicht benachbarte C-Atome durch -NR²-, -O-, -S-, -CO-. -CO-O-, -CO-NR²-, -O-CO-O ersetzt sein können, ein bivalentes aromatisches oder heteroaromatisches Ringsystem mit 2 bis 40 C-Atomen, welches mit R¹ substituiert oder unsubstituiert sein kann, eine mit R¹ substituierte oder unsubstituierte Vinyleneinheit, eine Acetyleneinheit oder eine Kombination aus 2 bis 5 dieser Systeme; die aromatischen Einheiten können dabei auch Teil eines größeren kondensierten Systems bilden; die möglichen Substituenten R¹ können optional an jeder freien Position sitzen;
R¹ ist bei jedem Auftreten gleich oder verschieden eine geradkettige, verzweigte oder cyclische Alkyl- oder Alkoxykette mit 1 bis 22 Atomen, in der auch ein oder mehrere nicht benachbarte C-Atome durch -NR²-. -O-, -S-, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R¹ substituiert sein kann, eine Vinyl- oder Acetylengruppe oder F, Cl, Br, I, NO₂, CN, N(R²)₂, B(R²)₂, Si(R²)₃, wobei auch zwei oder mehrere Reste R¹ miteinander ein aliphatisches oder aromatisches, mono- oder polycyclisches Ringsystem bilden können;
R² ist bei jedem Auftreten gleich oder verschieden H, eine geradkettige, verzweigte oder cyclische Alkylkette mit 1 bis 22 Atomen, in der auch ein oder mehrere nicht benachbarte C-Atome durch O, S, **-**CO-O**-,** O-CO-O ersetzt sein können, wobei auch ein der mehrere H-Atome durch Fluor ersetzt sein können, eine Arylgruppe mit 5 bis 40 C-Atomen, bei der auch ein oder mehrere C-Atome durch O. S oder N ersetzt sein können und welche auch durch einen oder mehrere nicht-aromatische Reste R² substituiert sein kann; dabei können auch zwei oder mehrere Reste R² miteinander ein Ringsystem bilden;
n ist bei jedem Auftreten gleich oder verschieden 0.1. 2, 3 oder 4. mit der Maßgabe, dass n nicht 4 sein darf, wenn eine Verknüpfung mit der Polymerkette (also X) an dieser Phenyleinheit erfolgt, und dass n nicht 3 oder 4 sein darf, wenn beide Verknüpfungen mit der Polymerkette (also X) an dieser Phenyleinheit erfolgen;
X beschreibt die Verknüpfung der Einheit mit dem konjugierten Polymer,
und/oder der Formel (II), 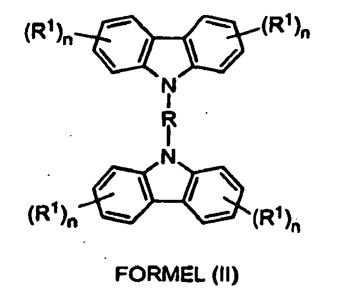 wobei die Symbole R, R¹, R² und die Indizes n dieselbe Bedeutung wie unter Formel **(I)** besitzen, und
(C) mindestens einen Triplett-Emitter.

2. Mischung gemäß Anspruch 1. **dadurch gekennzeichnet, dass** sie mindestens 0.5 Gew.% mindestens eines konjugierten Polymeren, mindestens 1 Gew.% mindestens einer überbrückten Carbazoleinheit gemäß Formel (I) und/oder Formel (II) und mindestens 0.1 Gew.% mindestens eines Triplett-Emitters enthält.

3. Mischungen BLEND1 gemäß Anspruch 1 oder 2, enthaltend
(A) 5 - 99.5 Gew.% mindestens eines konjugierten Polymers POLY1, das 1 -100 mol% einer oder mehrerer Einheiten gemäß Formel (I) enthält, 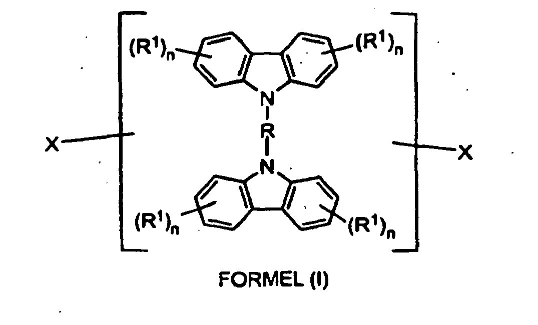 wobei die Symbole und Indizes dieselbe Bedeutung besitzen, wie unter Anspruch 1 beschrieben; und
(B) 0.1 - 95 Gew.% eines oder mehrerer Triplett-Emitter (VERB1).

4. Mischungen BLEND2 gemäß Anspruch 1 oder 2, enthaltend
(A) 0.5 - 99 Gew.% mindestens eines konjugierten Polymers POLY2, das 0.1 -100 mol% eines oder mehrerer Triplett-Emitter (VERB2) kovalent gebunden enthält und
(B) 1 - 99.5 Gew.% einer Struktureinheit gemäß Formel (II), 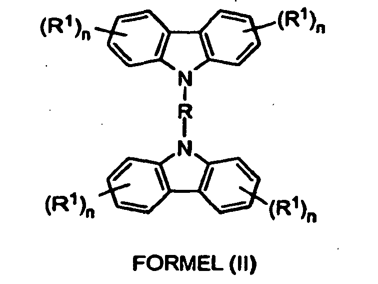
wobei die Symbole und Indizes dieselbe Bedeutung wie in Anspruch 1 besitzen.

5. Mischungen BLEND3 gemäß Anspruch 1 oder 2, enthaltend
(A) 0.5 - 98.5 Gew.% eines beliebigen konjugierten Polymers POLY3; und
(B) 1 - 99 Gew.% einer Struktureinheit gemäß Formel (II) 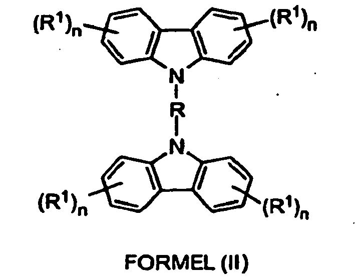 wobei die Symbole und Indizes dieselbe Bedeutung wie in Anspruch 1 besitzen; und
(C) 0.1 - 95 Gew.% eines oder mehrerer Triplett-Emitter (VERB1).

6. Mischungen BLEND4 gemäß Anspruch 1 oder 2, enthaltend
(A) 0.5 - 98.5 Gew.% mindestens eines beliebigen konjugierten Polymers POLY3; und
(B) 1.5 - 99.5 Gew.% einer Verbindung VERB3, die einen oder mehrere Triplett-Emitter kovalent an mindestens eine Struktureinheit gemäß Formel (II) gebunden enthält, 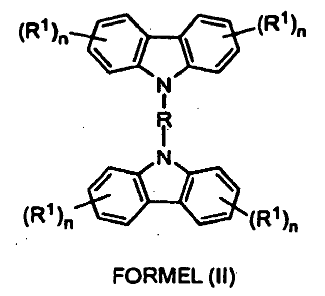
wobei die Symbole und Indizes dieselbe Bedeutung wie in Anspruch 1 besitzen und die Bindung zwischen dem Triplett-Emitter und der Struktureinheit gemäß Formel (II) an beliebigen Positionen des Triplett-Emitters und der Struktureinheit gemäß Formel (II) erfolgen kann.

7. Mischungen gemäß einem oder mehreren der Ansprüche 1 bis 6, **dadurch gekennzeichnet, dass** die Struktureinheiten gemäß Formel (I) über die 3,6-Position oder die 2,7-Position eines Carbazols in POLY1 eingebaut sind.

8. Mischungen gemäß einem oder mehreren der Ansprüche 1 bis 7, **dadurch gekennzeichnet, dass** die Struktureinheiten gemäß Formel (I) über die 3,3'-Position oder die 2,2'-Position beider Carbazoleinheiten in POLY1 eingebaut sind, sofern R eine Aryl-, Heteroaryl-, Vinyl- oder Acetyleneinheit oder eine Kombination dieser Systeme beschreibt.

9. Mischungen gemäß einem oder mehreren der Ansprüche 1 bis 8, **dadurch gekennzeichnet, dass** die Struktureinheiten gemäß Formel (I) über die Brücke R oder über ein oder zwei Substituenten R¹ in POLY1 eingebaut sind, sofern R bzw. R¹ eine Aryl-, Heteroaryl-, Stilbenyl- oder Tolanyleinheit oder eine Kombination dieser Systeme beschreibt.

10. Mischungen gemäß einem oder mehreren der Ansprüche 1 bis 9, **dadurch gekennzeichnet, dass** die weiteren Strukturelemente der Polymere POLY1 bis POLY3 aus den Gruppen ortho-, meta- oder para-Phenylene, 1,4-Naphthylene, 9,10-Anthracenylene, 2,7-Phenanthrenylene, 1,6- bzw. 2,7- bzw. 4,9-Pyrene oder 2,7-Tetrahydropyrene, Oxadiazolylene, 2,5-Thiophenylene, 2,5-Pyrrolylene, 2,5-Furanylene, 2,5-Pyridylene, 2,5-Pyrimidinylene, 5,8-Chinolinylene, Fluorene, Spiro-9,9'-bifluorene, Indenofluorene oder Heteroindenofluorene ausgewählt sind.

11. Mischungen gemäß einem oder mehreren der Ansprüche 1 bis 10, **dadurch gekennzeichnet, dass** in den Polymeren POLY1 bis POLY3 weitere Strukturelemente anwesend sind, die Ladungstransport und/oder die Ladungsinjektion und/oder das Ladungsgleichgewicht verbessern.

12. Mischungen gemäß Anspruch 11, **dadurch gekennzeichnet, dass** die weiteren Strukturelemente aus den Gruppen der Triarylamine bzw. der Oxadiazolylene ausgewählt sind.

13. Mischungen gemäß einem oder mehreren der Ansprüche 1 bis 12, **dadurch gekennzeichnet, dass** für die Symbole und Indizes der Formel (I) gilt:
R ist bei jedem Auftreten gleich oder verschieden eine geradkettige oder verzweigte Alkylenkette mit 3 bis 10 C-Atomen, die unsubstituiert oder mit R¹ substituiert sein kann, in der auch ein oder mehrere nicht benachbarte C-Atome durch N-R², O oder S ersetzt sein können, ein bivalentes aromatisches oder heteroaromatisches Ringsystem, ausgewählt aus Thiophen, Benzol, Biphenyl, Naphthalin, Anthracen oder Phenanthren, welches unsubstituiert oder mit ein oder zwei Substituenten R¹ substituiert sind, ein 9,9'-substituiertes Fluoren, ein mit 0 bis 4 Substituenten R¹ substituiertes Spirobifluoren, ein 9,10- oder 9,9, 10, 10-substituiertes Dihydrophenanthren, ein Stilbenyl- oder Tolanylsystem, welches an den freien Positionen 0 bis 2 Substituenten R¹ trägt, oder Kombinationen aus 2 bis 3 dieser Systeme;
R¹, R² sind wie in Anspruch 1 beschrieben;
n ist bei jedem Auftreten gleich oder verschieden 0, 1 oder 2;
die Verknüpfung mit der Polymerkette erfolgt über die 3,6- oder die 2,7-Position oder über die 3,3'-Position, sofern R ein Aryl-, Heteroaryl-, Stlibenyl- oder Tolanylsystem ist, oder über zwei Position an R selbst oder an R¹, sofern R bzw. R¹ ein Aryl-, Heteroaryl-, Stilbenyl- oder Tolanylsystem ist, so dass die Anzahl der aromatischen Atome zwischen den Verknüpfungsstellen ein Vielfaches von vier ist und, dass für die Symbole und Indizes der Formel (II) gilt:
R ist bei jedem Auftreten gleich oder verschieden eine geradkettige oder verzweigte Alkylkette mit 3 bis 10 C-Atomen, die unsubstituiert oder mit R¹ substituiert sein kann, in der auch ein oder mehrere nicht benachbarte C-atoms durch -NR²-. **-**O- oder -S- ersetzt sein können, ein bivalentes aromatisches oder heteroaromatisches Ringsystem, ausgewählt aus Thiophen, Benzol, Biphenyl. Naphthalin, Anthracen oder Phenanthren, welches unsubstituiert oder mit ein oder zwei Substituenten R¹ substituiert sind, ein 9,9'-substituiertes Fluoren, ein mit 0 bis 4 Substituenten R¹ substituiertes Spirobifluoren, ein 9,10**-** oder 9,9,10,10-substituiertes Dihydrophenanthren, ein Stilbenyl- oder Tolanylsystem, welches an den freien Positionen 0 bis 2 Substituenten R¹ trägt, oder Kombinationen aus 2 bis 3 dieser Systeme;
R¹, R² sind wie in Anspruch 1 beschrieben;
n ist bei jedem Auftreten gleich oder verschieden 0, 1 oder 2.

14. Mischungen gemäß einem oder mehreren der Ansprüche 1 bis 13, **dadurch gekennzeichnet, dass** die Strukturelemente gemäß Formel **(I)** aus den Formeln (III) bis (XXXVIII) ausgewählt werden, die substituiert oder unsubstituiert sein können.

15. Mischungen gemäß einem oder mehreren der Ansprüche 1 bis 14, **dadurch gekennzeichnet, dass** die Strukturelemente gemäß Formel (II) aus den Formeln (XXXIX) bis (LVIII) ausgewählt werden, die substituiert oder unsubstituiert sein können.

16. Mischungen gemäß einem oder mehreren der Ansprüche 1 bis 15, **dadurch gekennzeichnet, dass** der Triplett-Emitter Schweratome, also Atome aus dem Periodensystem der Elemente mit einer Ordnungszahl von mehr als 36, enthält.

17. Mischungen gemäß Anspruch 16, **dadurch gekennzeichnet, dass** der Triplett-Emitter d- und/oder f-Übergangsmetalle enthält.

18. Mischungen gemäß Anspruch 17, **dadurch gekennzeichnet, dass** der Triplett-Emitter Metalle der Gruppe 8 bis 10, insbesondere Ru, Os, Rh, Ir, Pd und/oder Pt, enthält.

19. Mischungen gemäß einem oder mehreren der Ansprüche 1 bis 18, **dadurch gekennzeichnet, dass** der Triplett**-**Emitter (VERB2) in die Hauptkette des Polymers (POLY2) eingebaut ist.

20. Mischungen gemäß einem oder mehreren der Ansprüche 1 bis 18, **dadurch gekennzeichnet, dass** der Triptett-Emitter (VERB2) in die Seitenkette des Polymers (POLY2) eingebaut ist.

21. Mischungen gemäß einem oder mehreren der Ansprüche 1 bis 20, **dadurch gekennzeichnet, dass** den Mischungen gemäß Anspruch 3 (BLEND1), Anspruch 4 (BLEND2), Anspruch 5 (BLEND3) oder Anspruch 6 (BLEND4) noch beliebige weitere Moleküle, die niedermolekular, oligomer, dendritisch oder polymer sein können, zugemischt werden.

22. Mischungen gemäß einem oder mehreren der Ansprüche 1 bis 21, **dadurch gekennzeichnet, dass** der Mischung gemäß Anspruch 3 (BLEND1) oder Anspruch 6 (BLEND4) zusätzlich Struktureinheiten gemäß Formel (II) zugemischt werden.

23. Mischungen gemäß Anspruch 22, **dadurch gekennzeichnet, dass** der Gesamtanteil an Struktureinheiten gemäß Formel (I) und Formel (II) 20 - 99 mol% beträgt.

24. Konjugierte Polymere (POLY4), enthaltend
(A) 1 - 99.9 mol% Einheiten gemäß Formel (I), 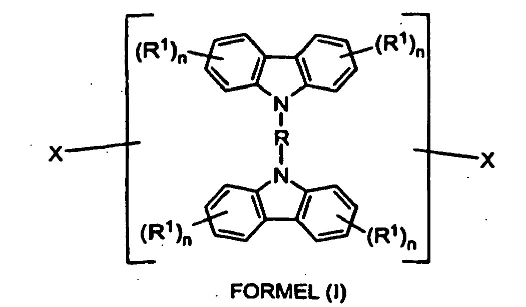 wobei die Symbole und Indizes dieselbe Bedeutung haben, wie in Anspruch 1 definiert, und
(B) 0.1 - 95 mol% eines oder mehrerer Triplett-Emitter.

25. Mischungen aus mindestens einem Polymer gemäß Anspruch 24, **dadurch gekennzeichnet, dass** dem Polymer (POLY4) weitere Moleküle, die niedermolekular, oligomer, dendritisch oder polymer sein können, zugemischt werden.

26. Verbindungen gemäß Formel (LIX), 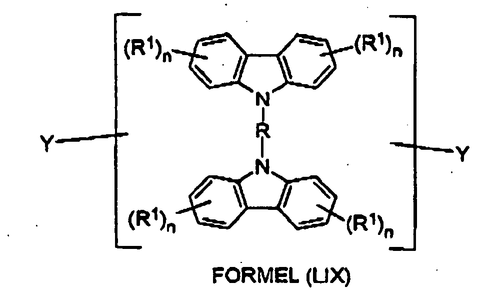 **dadurch gekennzeichnet, dass** die beiden funktionellen Gruppen Y, gleich oder verschieden, unter Bedingungen der C-C- bzw, C-N-Verknüpfungen copolymerisieren und für die weiteren Symbole und Indizes gilt:
R ist bei jedem Auftreten gleich oder verschieden eine geradkettige, verzweigte oder cyclische Alkylenkette mit 1 bis 40 C-Atomen, die mit R¹ substituiert oder unsubstituiert sein kann, in der auch ein oder mehrere nicht benachbarte C-Atome durch -NR²-, -S-, -CO-, -CO-O-, **-**CO**-**NR²-, -O-CO-O ersetzt sein können, ein bivalentes aromatisches oder heteroaromatisches Ringsystem mit 2 bis 40 C-Atomen, welches mit R¹ substituiert oder unsubstituiert sein kann, eine mit R¹ substituierte oder unsubstituierte Vlnyleneinheit oder eine Kombination aus 2 bis 5 dieser Systeme; die aromatischen Einheiten können dabei auch Teil eines größeren kondensierten Systems bilden; die möglichen Substituenten R¹ können optional an jeder freien Position sitzen;
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -NA²-, -S-, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R¹ substituiert sein kann, eine Vinyl- oder Acetylengruppe oder F, Cl, Br, I, NO₂, CN, N(R²)₂, S(R²)₂, Si(R²)_{3,} wobei auch zwei oder mehrere Reste R¹ miteinander ein aliphatisches oder aromatisches, mono- oder polycyclisches Ringsystem bilden können;
R² ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können und welche auch durch einen oder mehrere nicht-aromatische Reste R² substituiert sein kann; dabei können auch zwei oder mehrere Reste R² miteinander ein Ringsystem bilden;
n ist bei jedem Auftreten gleich oder verschieden 0, 1, 2, 3 oder 4, mit der Maßgabe, dass n nicht 4 sein darf, wenn eine Verknüpfung mit Y an dieser Phenyleinheit erfolgt, und dass n nicht 3 oder 4 sein darf, wenn beide Verknüpfungen mit Y an dieser Phenyleinheit erfolgen;
ausgenommen sind dabei die folgenden Verbindungen:

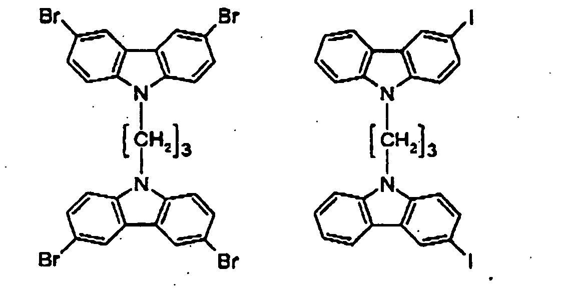

27. Verbindungen gemäß Anspruch 26, **dadurch gekennzeichnet, dass** Y ausgesucht ist aus den Gruppen Cl, Br, I, O-Tosylat, O-Triflat, OSO₂R², B(OH)_{2,} B(OR²)₂, Sn(R²)₃ und NHR², wobei R² dieselbe Bedeutung wie in Anspruch 26 hat.

28. Verbindungen gemäß Anspruch 26 und/oder 27, **dadurch gekennzeichnet, dass** die C-C- bzw. C-N-Verknüpfungen ausgewählt sind aus den Gruppen der SUZUKI-Kupplung, der YAMAMOTO-Kupplung, der STILLE-Kupplung und der HARTWIG-BUCHWALD-Kupplung.

29. Verbindungen gemäß einem oder mehreren der Ansprüche 26 bis 28, **dadurch gekennzeichnet, dass** die monomeren Verbindungen gemäß Formel (LIX) im Polymer zu Struktureinheiten gemäß Formel (III) bis (XXXVIII) führen.

30. Verwendung einer Mischung oder eines Polymers gemäß einem oder mehreren der Ansprüche 1 bis 25 in organischen Leuchtdioden (OLED), organischen Solarzellen (O-SCs), organischen Laserdioden (O-Laser), organischen optischen Detektoren oder in der nicht-linearen Optik.

31. Elektronisches Bauteil, welches eine oder mehrere aktive Schichten umfasst, wobei mindestens eine dieser Schichten ein oder mehrere Mischungen oder Polymere gemäß einem oder mehreren der Ansprüche 1 bis 25 enthält.

32. Elektronisches Bauteil gemäß Anspruch 31, **dadurch gekennzeichnet, dass** es sich um eine organische Leuchtdiode, organische Solarzelle, organische Laserdiode, einen organischen optischen Detektor oder eine Vorrichtung für nicht-lineare Optik handelt.

## Claims

1. Mixtures (blends) comprising
(A) at least one conjugated polymer,
(B) at least one bridged carbazole unit of the formula (I) 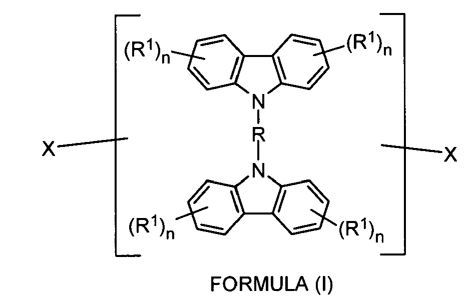 where the symbols and indices have the following meaning:
R is on each occurrence, identically or differently, a straight-chain, branched or cyclic alkylene chain having 1 to 40 C atoms, which may be substituted by R¹ or unsubstituted and in which one or more non-adjacent C atoms may be replaced by -NR²-, -O-, -S-, -CO-, -CO-O-, -CO-NR²-, -O-CO-O, a divalent aromatic or heteroaromatic ring system having 2 to 40 C atoms, which may be substituted by R¹ or unsubstituted, a vinylene unit which is substituted by R¹ or unsubstituted, an acetylene unit or a combination of 2 to 5 of these systems; the aromatic units here may also form part of a larger condensed system; the possible substituents R¹ may optionally be in any free position;
R¹ is on each occurrence, identically or differently, a straight-chain, branched or cyclic alkyl or alkoxy chain having 1 to 22 C atoms, in which, in addition, one or more non-adjacent C atoms may be replaced by -NR²-, -O-, -S-, -CO-O-, O-CO-O and in which one or more H atoms may be replaced by fluorine, an aryl or aryloxy group having 5 to 40 C atoms, in which, in addition, one or more C atoms may be replaced by O, S or N and which may also be substituted by one or more non-aromatic radicals R¹, a vinyl or acetylene group or F, Cl, Br, I, NO₂, CN, N(R²)₂, B(R²)₂, Si(R²)₃, where, in addition, two or more radicals R¹ may form an aliphatic or aromatic, mono- or polycyclic ring system with one another;
R² is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O and in which one or more H atoms may be replaced by fluorine, an aryl group having 5 to 40 C atoms, in which, in addition, one or more C atoms may be replaced by O, S or N and which may also be substituted by one or more non-aromatic radicals R²; two or more radicals R² here may also form a ring system with one another;
n is on each occurrence, identically or differently, 0, 1, 2, 3 or 4, with the proviso that n cannot be 4 if one linking to the polymer chain (i.e. X) takes place at this phenyl unit, and that n cannot be 3 or 4 if both linkings to the polymer chain (i.e. X) take place at this phenyl unit;
X describes the link of the unit to the conjugated polymer,
and/or of the formula (II) 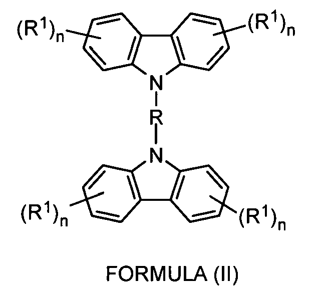 where the symbols R, R¹, R² and the indices n have the same meaning as under formula (I),
and
(C) at least one triplet emitter.

2. Mixture according to Claim 1, **characterised in that** it comprises at least 0.5% by weight of at least one conjugated polymer, at least 1% by weight of at least one bridged carbazole unit of the formula (I) and/or formula (II) and at least 0.1 % by weight of at least one triplet emitter.

3. Mixtures BLEND1 according to Claim 1 or 2, comprising
(A) 5 - 99.5% by weight of at least one conjugated polymer POLY1, which contains 1 - 100 mol% of one or more units of the formula (I) 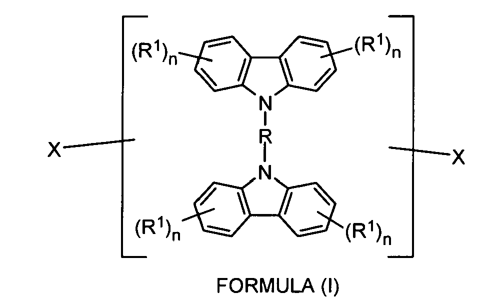 where the symbols and indices have the same meaning as described under Claim 1; and
(B) 0.1 - 95% by weight of one or more triplet emitters (COMP1).

4. Mixtures BLEND2 according to Claim 1 or 2, comprising
(A) 0.5 - 99% by weight of at least one conjugated polymer POLY2, which contains 0.1 - 100 mol% of one or more covalently bonded triplet emitters (COMP2) and
(B) 1 - 99.5% by weight of a structural unit of the formula (II) 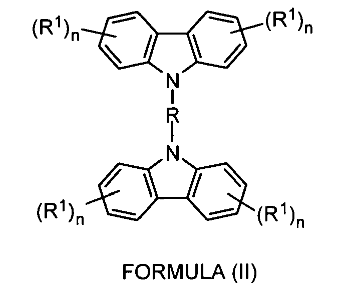
where the symbols and indices have the same meaning as in Claim 1.

5. Mixtures BLEND3 according to Claim 1 or 2, comprising
(A) 0.5 - 98.5% by weight of a conjugated polymer POLY3 of any desired type; and
(B) 1 - 99% by weight of a structural unit of the formula (II) 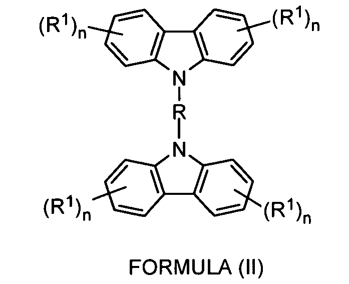 where the symbols and indices have the same meaning as in Claim 1; and
(C) 0.1 - 95% by weight of one or more triplet emitters (COMP1).

6. Mixtures BLEND4 according to Claim 1 or 2, comprising
(A) 0.5 - 98.5% by weight of at least one conjugated polymer POLY3 of any desired type;
and
(B) 1.5 - 99.5% by weight of a compound COMP3, which contains one or more triplet emitters covalently bonded to at least one structural unit of the formula (II) 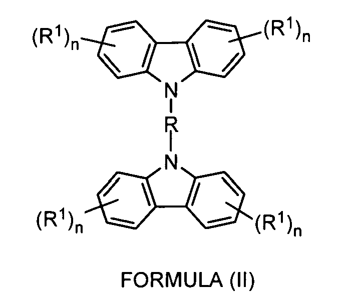
where the symbols and indices have the same meaning as in Claim 1, and the bonding between the triplet emitter and the structural unit of the formula (II) can take place at any desired positions of the triplet emitter and the structural unit of the formula (II).

7. Mixtures according to one or more of Claims 1 to 6, **characterised in that** the structural units of the formula (I) are incorporated into POLY1 via the 3,6-position or the 2,7-position of one carbazole.

8. Mixtures according to one or more of Claims 1 to 7, **characterised in that** the structural units of the formula (I) are incorporated into POLY1 via the 3,3'-position or the 2,2'-position of the two carbazole units if R describes an aryl, heteroaryl, vinyl or acetylene unit or a combination of these systems.

9. Mixtures according to one or more of Claims 1 to 8, **characterised in that** the structural units of the formula (I) are incorporated into POLY1 via the bridge R or via one or two substituents R¹ if R or R¹ describes an aryl, heteroaryl, stilbenyl or tolanyl unit or a combination of these systems.

10. Mixtures according to one or more of Claims 1 to 9, **characterised in that** the further structural elements of polymers POLY1 to POLY3 are selected from the groups ortho-, meta- or para-phenylenes, 1,4-naphthylenes, 9,10-anthracenylenes, 2,7-phenanthrenylenes, 1,6- or 2,7- or 4,9-pyrenes or 2,7-tetrahydropyrenes, oxadiazolylenes, 2,5-thiophenylenes, 2,5-pyrrolylenes, 2,5-furanylenes, 2,5-pyridylenes, 2,5-pyrimidinylenes, 5,8-quinolinylenes, fluorenes, spiro-9,9'-bifluorenes, indenofluorenes or hetero-indenofluorenes.

11. Mixtures according to one or more of Claims 1 to 10, **characterised in that** further structural elements which improve charge transport and/or charge injection and/or the charge equilibrium are present in polymers POLY1 to POLY3.

12. Mixtures according to Claim 11, **characterised in that** the further structural elements are selected from the groups of the triarylamines or oxadiazolylenes.

13. Mixtures according to one or more of Claims 1 to 12, **characterised in that** the following applies to the symbols and indices in the formula (I):
R is on each occurrence, identically or differently, a straight-chain or branched alkylene chain having 3 to 10 C atoms, which may be unsubstituted or substituted by R¹ and in which one or more non-adjacent C atoms may be replaced by N-R², O or S, a divalent aromatic or heteroaromatic ring system selected from thiophene, benzene, biphenyl, naphthalene, anthracene or phenanthrene, each of which is unsubstituted or substituted by one or two substituents R¹, a 9,9'-substituted fluorene, a spirobifluorene which is substituted by 0 to 4 substituents R¹, a 9,10- or 9,9,10,10-substituted dihydrophenanthrene, a stilbenyl or tolanyl system which carries 0 to 2 substituents R¹ in the free positions, or combinations of 2 to 3 of these systems;
R¹, R² are as described in Claim 1;
n is on each occurrence, identically or differently, 0, 1 or 2;
the linking to the polymer chain takes place via the 3,6- or 2,7-position or via the 3,3'-position if R is an aryl, heteroaryl, stilbenyl or tolanyl system, or via two positions on R itself or on R¹ if R or R¹ is an aryl, heteroaryl, stilbenyl or tolanyl system, so that the number of aromatic atoms between the linking points is a multiple of four and that the following applies to the symbols and indices in the formula (II):
R is on each occurrence, identically or differently, a straight-chain or branched alkyl chain having 3 to 10 C atoms, which may be unsubstituted or substituted by R¹ and in which one or more non-adjacent C atoms may be replaced by -NR²-, -O- or -S-, a divalent aromatic or heteroaromatic ring system selected from thiophene, benzene, biphenyl, naphthalene, anthracene or phenanthrene, each of which is unsubstituted or substituted by one or two substituents R¹, a 9,9'-substituted fluorene, a spirobifluorene which is substituted by 0 to 4 substituents R¹, a 9,10- or 9,9,10,10-substituted dihydrophenanthrene, a stilbenyl or tolanyl system which carries 0 to 2 substituents R¹ in the free positions, or combinations of 2 to 3 of these systems;
R¹, R² are as described in Claim 1;
n is on each occurrence, identically or differently, 0, 1 or 2.

14. Mixtures according to one or more of Claims 1 to 13, **characterised in that** the structural elements of the formula (I) are selected from the formulae (III) to (XXXVIII), which may be substituted or unsubstituted.

15. Mixtures according to one or more of Claims 1 to 14, **characterised in that** the structural elements of the formula (II) are selected from the formulae (XXXIX) to (LVIII), which may be substituted or unsubstituted.

16. Mixtures according to one or more of Claims 1 to 15, **characterised in that** the triplet emitter contains heavy atoms, i.e. atoms from the Periodic Table of the Elements having an atomic number of greater than 36.

17. Mixtures according to Claim 16, **characterised in that** the triplet emitter contains d and/or f transition metals.

18. Mixtures according to Claim 17, **characterised in that** the triplet emitter contains metals from groups 8 to 10, in particular Ru, Os, Rh, Ir, Pd and/or Pt.

19. Mixtures according to one or more of Claims 1 to 18, **characterised in that** the triplet emitter (COMP2) is incorporated into the main chain of the polymer (POLY2).

20. Mixtures according to one or more of Claims 1 to 18, **characterised in that** the triplet emitter (COMP2) is incorporated into the side chain of the polymer (POLY2).

21. Mixtures according to one or more of Claims 1 to 20, **characterised in that** the mixtures according to Claim 3 (BLEND1), Claim 4 (BLEND2), Claim 5 (BLEND3) or Claim 6 (BLEND4) are additionally admixed with any desired further molecules, which may be low-molecular-weight, oligomeric, dendritic or polymeric.

22. Mixtures according to one or more of Claims 1 to 21, **characterised in that** the mixture according to Claim 3 (BLEND1) or Claim 6 (BLEND4) is additionally admixed with structural units of the formula (II).

23. Mixtures according to Claim 22, **characterised in that** the total proportion of structural units of the formula (I) and formula (II) is 20 - 99 mol%.

24. Conjugated polymers (POLY4) containing
(A) 1 - 99.9 mol% of units of the formula (I) 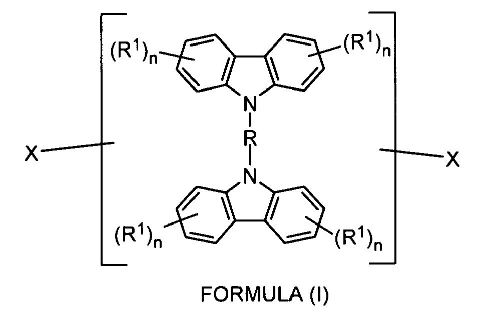 where the symbols and indices have the same meaning as defined in Claim 1, and
(B) 0.1 - 95 mol% of one or more triplet emitters.

25. Mixtures comprising at least one polymer according to Claim 24, **characterised in that** the polymer (POLY4) is admixed with further molecules, which may be low-molecular-weight, oligomeric, dendritic or polymeric.

26. Compounds of the formula (LIX) 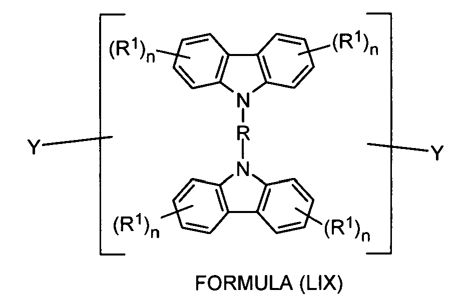 **characterised in that** the two functional groups Y, identically or differently, copolymerise under the conditions of C-C or C-N linkings and the following applies to the other symbols and indices:
R is on each occurrence, identically or differently, a straight-chain, branched or cyclic alkylene chain having 1 to 40 C atoms, which may be substituted by R¹ or unsubstituted and in which one or more non-adjacent C atoms may be replaced by -NR²-, -S-, -CO-, -CO-O-, -CO-NR²- -O-CO-O, a divalent aromatic or hetero-aromatic ring system having 2 to 40 C atoms, which may be substituted by R¹ or unsubstituted, a vinylene unit which is substituted by R¹ or unsubstituted, or a combination of 2 to 5 of these systems; the aromatic units here may also form part of a larger condensed system; the possible substituents R¹ may optionally be in any free position;
R¹ is on each occurrence, identically or differently, a straight-chain, branched or cyclic alkyl or alkoxy chain having 1 to 22 C atoms, in which, in addition, one or more non-adjacent C atoms may be replaced by -NR²-, -S-, -CO-O-, O-CO-O and in which one or more H atoms may be replaced by fluorine, an aryl or aryl-oxy group having 5 to 40 C atoms, in which, in addition, one or more C atoms may be replaced by O, S or N and which may also be substituted by one or more non-aromatic radicals R¹, a vinyl or acetylene group or F, Cl, Br, I, NO₂, CN, N(R²)_{2,} B(R²)₂, Si(R²)₃, where, in addition, two or more radicals R¹ may form an aliphatic or aromatic, mono- or polycyclic ring system with one another;
R² is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O and in which one or more H atoms may be replaced by fluorine, an aryl group having 5 to 40 C atoms, in which, in addition, one or more C atoms may be replaced by O, S or N and which may also be substituted by one or more non-aromatic radicals R²; two or more radicals R² here may also form a ring system with one another;
n is on each occurrence, identically or differently, 0, 1, 2, 3 or 4, with the proviso that n cannot be 4 if one linking to Y takes place at this phenyl unit, and that n cannot be 3 or 4 if both linkings to Y take place at this phenyl unit;
the following compounds are excepted here:

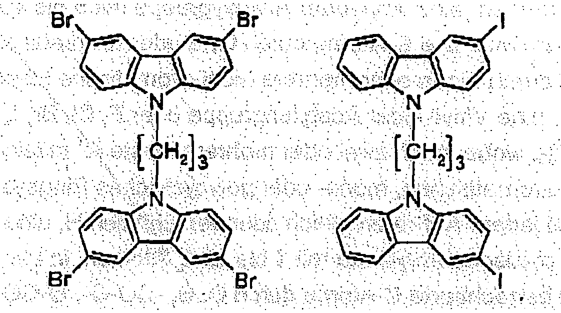

27. Compounds according to Claim 26, **characterised in that** Y is selected from the groups Cl, Br, I, O-tosylate, O-triflate, OSO₂R², B(OH)₂, B(OR²)₂, Sn(R²)₃ and NHR², where R² has the same meaning as in Claim 26.

28. Compounds according to Claim 26 and/or 27, **characterised in that** the C-C and C-N linkings are selected from the groups of the SUZUKI coupling, the YAMAMOTO coupling, the STILLE coupling and the HARTWIG-BUCHWALD coupling.

29. Compounds according to one or more of Claims 26 to 28, **characterised in that** the monomeric compounds of the formula (LIX) lead to structural units of the formulae (III) to (XXXVIII) in the polymer.

30. Use of a mixture or a polymer according to one or more of Claims 1 to 25 in organic light-emitting diodes (OLEDs), organic solar cells (O-SCs), organic laser diodes (O-lasers), organic optical detectors or in non-linear optics.

31. Electronic component which comprises one or more active layers, where at least one of these layers comprises one or more mixtures or polymers according to one or more of Claims 1 to 25.

32. Electronic component according to Claim 31, **characterised in that** it is an organic light-emitting diode, organic solar cell, organic laser diode, organic optical detector or a device for non-linear optics.

## Revendications

1. Mélanges (blends) comprenant
(A) au moins un polymère conjugué,
(B) au moins une unité de carbazole pontée de la formule (I) 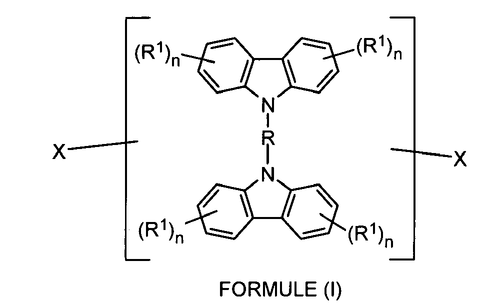 dans laquelle les symboles et indices ont la signification qui suit:
R est à chaque occurrence, de façon identique ou différente, une chaîne alkylène en chaîne droite, ramifiée ou cyclique ayant 1 à 10 atomes de C, qui peut être substituée par R¹ ou non substituée et dans laquelle un ou plusieurs atomes de C non adjacents(s) peut/peuvent être remplacé(s) par -NR²-, -O-, -S-, -CO-, -CO-O-, -CO-NR²-, -O-CO-O, un système de cycle aromatique ou hétéroaromatique divalent ayant 2 à 40 atomes de C, qui peut être substitué par R¹ ou non substitué, une unité vinylène qui est substituée par R¹ ou non substituée, une unité acétylène ou une combinaison de 2 à 5 de ces systèmes; les unités aromatiques peuvent ici également faire partie d'un système condensé plus large, les substituants possibles R¹ peuvent en option être en une quelconque position libre;
R¹ est à chaque occurrence, de façon identique ou différente, une chaîne alkyle ou alcoxy en chaîne droite, ramifiée ou cyclique ayant 1 à 22 atomes de C, dans laquelle en addition, un ou plusieurs atomes de C non adjacent(s) peut/peuvent être remplacé(s) par -NR²-, -O-, -S-, -CO-O-, O-CO-O et dans laquelle un ou plusieurs atomes de H peut/peuvent être remplacé(s) par fluor, un groupe aryle ou aryloxy ayant 5 à 40 atomes de C, dans lequel, en addition, un ou plusieurs atomes de C peut/peuvent être remplacé(s) par O, S ou N et qui peut/peuvent être également substitué(s) par un ou plusieurs radicaux non aromatiques R¹, un groupe vinyle ou acétylène ou F, Cl, Br, I, NO₂, CN, N(R²)₂, B(R²)₂, Si(R²)₃, dans lequel, en addition, deux ou plus de deux radicaux R¹ peut/peuvent former un système de cycle mono- ou polycyclique, aliphatique ou aromatique l'un avec l'autre;
R² est à chaque occurrence, de façon identique ou différente, H, une chaîne alkyle en chaîne droite, ramifiée ou cyclique ayant 1 à 22 atomes de C, dans lequel, en addition, un ou plusieurs atomes de C non adjacents peut/peuvent être remplacé(s) par O, S, -CO-O-, O-CO-O et dans lequel un ou plusieurs atomes de H peut/peuvent être remplacé(s) par fluor, un groupe aryle ayant 5 à 40 atomes de C, dans lequel, en addition, un ou plusieurs atomes de C peut/peuvent être remplacé(s) par O, S ou N et qui peut/peuvent être également substitué(s) par un ou plusieurs radicaux non aromatiques R²; deux ou plus de deux radicaux R² peuvent ici également former un système de cycle l'un avec l'autre;
n est à chaque occurrence, de façon identique ou différente, 0, 1, 2, 3 ou 4, étant entendu que n ne peut pas être 4 si une seule liaison à la chaîne polymère (c'est-à-dire X) s'instaure à cette unité phényle, et que n ne peut pas être 3 ou 4 si toutes les liaisons à la chaîne polymère (c'est-à-dire X) s'instaurent à cette unité phényle;
X décrit la liaison de l'unité au polymère conjugué,
et/ou de la formule (II) 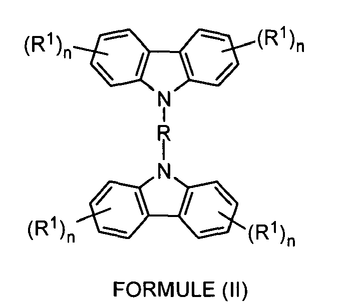 dans laquelle les symboles R, R¹, R² et les indices n ont la même signification que pour la formule (1), et
(C) au moins un émetteur triplet.

2. Mélange selon la revendication 1, **caractérisé en ce qu'**il comprend au moins 0,5% en poids d'au moins un polymère conjugué, au moins 1 % en poids d'au moins une unité carbazole de la formule (I) et/ou la formule (II) et au moins 0,1% en poids d'au moins un émetteur triplet.

3. Mélanges BLEND1 selon la revendication 1 ou 2, comprenant
(A) 5 - 99.5% en poids d'au moins un polymère conjugué POLY1, qui contient 1 - 100 mol% d'une ou plusieurs unités de la formule (I) 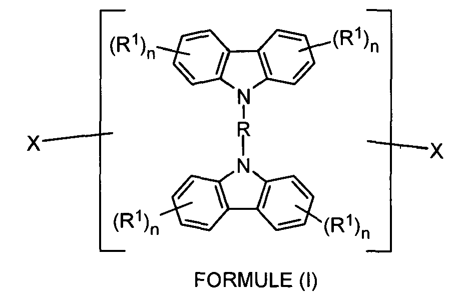 dans laquelle les symboles et indices ont les mêmes significations que pour la revendication 1; et
(B) 0,1 - 95% en poids d'un ou plusieurs émetteurs triplets (COMP1).

4. Mélanges BLEND2 selon la revendication 1 ou 2, comprenant
(A) 0,5 - 99% en poids d'au moins un polymère conjugué POLY2, qui contient 0,1 - 100 mol% d'un ou plusieurs émetteurs triplet liés de façon covalente (COMP2) et
(B) 1 - 99,5% en poids d'une unité structurale de la formule (II) 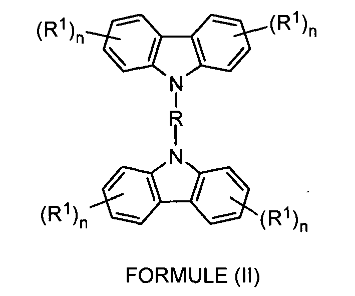
dans laquelle les symboles et indices ont les mêmes significations que dans la revendication 1.

5. Mélanges BLEND3 selon la revendication 1 ou 2, comprenant
(A) 0,5 - 98,5% en poids d'un polymère conjugué POLY3 d'un quelconque type souhaité;
et
(B) 1 - 99% en poids d'une unité structurale de la formule (II) 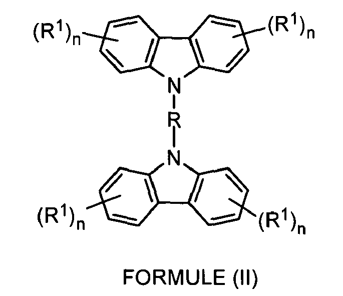 dans laquelle les symboles et indices ont les mêmes significations que dans la revendication 1; et
(C) 0,1 - 95% en poids d'un ou plusieurs émetteurs triplet (COMP1).

6. Mélanges BLEND4 selon la revendication 1 ou 2, comprenant
(A) 0,5 - 98,5% en poids d'au moins un polymère conjugué POLY3 d'un quelconque type souhaité;
et
(B) 1,5 - 99,5% en poids d'un composé COMP3, qui contient un ou plusieurs émetteurs triplet liés de façon covalente à au moins une unité structurelle de la formule (II) 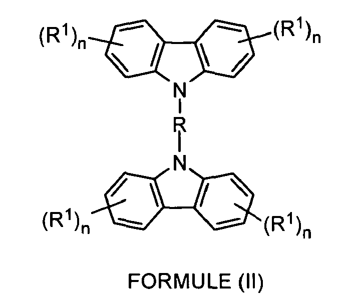
dans laquelle les symboles et indices ont les mêmes significations que dans la revendication 1, et la liaison entre l'émetteur triplet et l'unité structurelle de la formule (II) peut s'instaurer en de quelconques positions de l'émetteur triplet et l'unité structurelle de la formule (II).

7. Mélanges selon une ou plusieurs des revendications 1 à 6, **caractérisés en ce que** les unités structurelles de la formule (I) sont incorporées dans POLY1 via la position 3,6 ou la position 2,7 d'un carbazole.

8. Mélanges selon une ou plusieurs des revendications 1 à 7, les unités structurelles de la formule (I) sont incorporées dans POLY1 via la position 3,3' ou via la position 2,2' des deux unités carbazole si R décrit une unité aryle, hétéroaryle, vinyle ou acétylène ou une combinaison de ces systèmes.

9. Mélanges selon une ou plusieurs des revendications 1 à 8, **caractérisés en ce que** les unités structurelles de la formule (I) sont incorporées dans POLY1 via le pont R ou via un ou deux substituants R¹ si R ou R¹ décrit une unité aryle, hétéroaryle, stilbényle ou tolanyle ou une combinaison de ces systèmes.

10. Mélanges selon une ou plusieurs des revendications 1 à 9, **caractérisés en ce que** les autres éléments structurels des polymères POLY1 à POLY3 sont choisis parmi les groupes ortho-, méta- ou para-phénylènes, 1,4-naphtylènes, 9,10-anthracénylènes, 2,7-phenanthrénylènes, 1,6- ou 2,7- ou 4,9-pyrènes ou 2,7-tétrahydropyrènes, oxadiazolylènes, 2,5-thiophénylènes, 2,5-pyrrolylènes, 2,5-furanylènes, 2,5-pyridylènes, 2,5-pyrimidinylènes, 5,8-quinolinylènes, fluorènes, spiro-9,9'-bifluorènes, indénofluorènes ou hétéroindénofluorènes.

11. Mélanges selon une ou plusieurs des revendications 1 à 10, **caractérisés en ce que** d'autres éléments structurels qui améliorent le transport de charges et/ou l'injection de charges et/ou l'équilibre de charges sont présents dans les polymères POLY1 à POLY3.

12. Mélanges selon la revendication 11, **caractérisés en ce que** les autres éléments structurels sont choisis parmi les groupes des triarylamines ou oxadiazolylènes.

13. Mélanges selon une ou plusieurs des revendications 1 à 12, **caractérisés en ce que** ce qui suit s'applique aux symboles et indices dans la formule (I):
R est à chaque occurrence, de façon identique ou différente, une chaîne alkylène en chaîne droite ou ramifiée ayant 3 à 10 atomes de C, qui peut être non substituée ou substituée par R¹ et dans lequel un ou plusieurs atomes de C non adjacents peut/peuvent être remplacé(s) par N-R², O ou S, un système de cycle aromatique ou hétéroaromatique divalent choisi parmi thiophènes, benzène, biphényle, naphtalène, anthracène ou phénanthrène, dont chacun est non substitué ou substitué par un ou deux substituants R¹, un fluorène 9,9'-substitué, un spirobifluorène qui est substitué par 0 à 4 substituants R¹, un dihydrophénanthrène 9,10- ou 9,9,10,10-substitué , un système stilbényle ou tolanyle qui porte 0 à 2 substituants R¹ dans les positions libres, ou des combinaisons de 2 à 3 de ces systèmes;
R¹, R² sont comme décrits dans la revendication 1;
n est à chaque occurrence, de façon identique ou différente, 0, 1 ou 2;
les liaisons à la chaîne polymère s'instaurent via la position 3,6 ou 2,7 ou via la position 3,3' si R est un système aryle, hétéroaryle, stilbényle ou tolanyle, ou via deux positions sur R lui-même ou sur R¹ si R ou R¹ est un système aryle, hétéroaryle, stilbényle ou tolanyle, de telle sorte que le nombre d'atomes aromatiques entre les points de liaison soit un multiple de quatre et ce qui suit s'applique aux symboles et indices dans la formule (II):
R est à chaque occurrence, de façon identique ou différente, une chaîne alkyle en chaîne droite ou ramifiée ayant 3 à 10 atomes de C, qui peut être non substituée ou substituée par R¹ et dans lequel un ou plusieurs atomes de C non adjacents peut/peuvent être remplacé(s) par -NR²-, -O- ou -S-, un système de cycle aromatique ou hétéroaromatique divalent choisi parmi thiophène, benzène, biphényle, naphtalène, anthracène ou phénanthrène, dont chacun est non substitué ou substitué par un ou deux substituants R¹, un fluorène 9,9'-substitué, un spiro-bifluorène qui est substitué par 0 à 4 substituants R¹, un dihydrophénanthrène 9,10- ou 9,9,10,10-substitué, un système stilbényle ou tolanyle qui porte 0 à 2 substituants R¹ dans les positions libres, ou des combinaisons de 2 à 3 de ces systèmes;
R¹, R² sont comme décrits dans la revendication 1;
n est à chaque occurrence, de façon identique ou différente, 0, 1 ou 2.

14. Mélanges selon une ou plusieurs des revendications 1 à 13, **caractérisés en ce que** les éléments structurels de la formule (I) sont choisis parmi les formules (III) à (XXXVIII), qui peuvent être substituées ou non substituées.

15. Mélanges selon une ou plusieurs des revendications 1 à 14, **caractérisés en ce que** les éléments structurels de la formule (II) sont choisis parmi les formules (XXXIX) à (LVIII), qui peuvent être substituées ou non substituées.

16. Mélanges selon une ou plusieurs des revendications 1 à 15, **caractérisés en ce que** l'émetteur triplet contient des atomes lourds, c'est-à-dire des atomes du Tableau Périodique des Eléments ayant un numéro atomique supérieur à 36.

17. Mélanges selon la revendication 16, **caractérisés en ce que** l'émetteur triplet contient d et/ou f métaux de transition.

18. Mélanges selon la revendication 17, **caractérisés en ce que** l'émetteur triplet contient des métaux parmi les groupes 8 à 10, en particulier Ru, Os, Rh, Ir, Pd et/ou Pt.

19. Mélanges selon une ou plusieurs des revendications 1 à 18, **caractérisés en ce que** l'émetteur triplet (COMP2) est incorporé dans la chaîne principale du polymère (POLY2).

20. Mélanges selon une ou plusieurs des revendications 1 à 18, **caractérisés en ce que** l'émetteur triplet (COMP2) est incorporé dans la chaîne latérale du polymère (POLY2).

21. Mélanges selon une ou plusieurs des revendications 1 à 20, **caractérisés en ce que**, aux mélanges selon la revendication 3 (BLEND1), la revendication 4 (BLEND2), la revendication 5 (BLEND3) ou la revendication 6 (BLEND4) sont additionnellement ajoutées par mélange de quelconques autres molécules souhaitées, qui peuvent être oligomériques, dendritiques ou polymériques à faibles poids moléculaires.

22. Mélanges selon une ou plusieurs des revendications 1 à 21, **caractérisés en ce que**, au mélange selon la revendication 3 (BLEND1) ou la revendication 6 (BLEND4) sont additionnellement ajoutées par mélange des unités structurelles de la formule (II).

23. Mélanges selon la revendication 22, **caractérisés en ce que** la proportion totale d'unités structurelles de la formule (I) et la formule (II) est 20 - 99 mol%.

24. Polymères conjugués (POLY4) contenant
(A) 1 - 99,9 mol% d'unités de la formule (I) 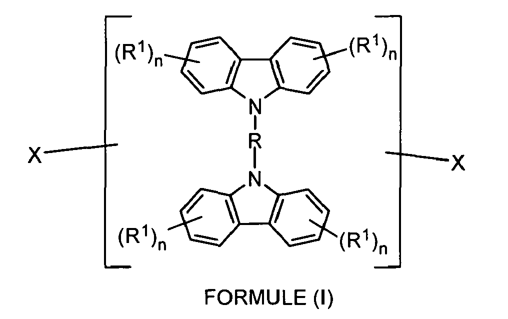 dans laquelle les symboles et indices ont les mêmes significations que définies dans la revendication 1, et
(B) 0,1 -95 mol% d'un ou plusieurs émetteurs triplet.

25. Mélanges comprenant au moins un polymère selon la revendication 24, **caractérisés en ce que**, au polymère (POLY4) sont ajoutées par mélange d'autres molécules, qui peuvent être oligomériques, dendritiques ou polymériques à faibles poids moléculaires.

26. Composés de la formule (LIX) 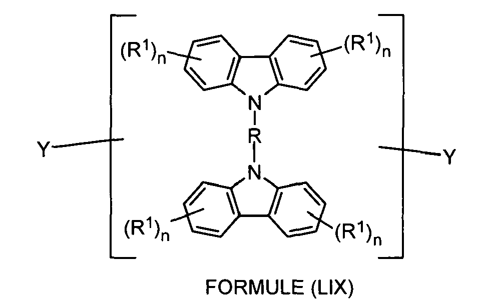 **caractérisés en ce que** les deux groupes fonctionnels Y, de façon identique ou différente, copolymérisent sous les conditions de liaisons C-C ou C-N et ce qui suit s'applique aux autres symboles et indices:
R est à chaque occurrence, de façon identique ou différente, une chaîne alkylène en chaîne droite, ramifiée ou cyclique ayant 1 à 40 atomes de C,qui peut être substituée par R¹ ou non substituée et dans laquelle un ou plusieurs atomes de C non adjacents(s) peut/peuvent être remplacé(s) par -NR²-, -S-, -CO-, -CO-O-, -CO-NR²-, -O-CO-O, un système de cycle aromatique ou hétéroaromatique divalent ayant 2 à 40 atomes de C, qui peut être substitué par R¹ ou non substitué, une unité vinylène qui est substituée par R¹ ou non substituée, ou une combinaison de 2 à 5 de ces systèmes; les unités aromatiques peuvent ici également faire partie d'un système condensé plus large; les substituants possibles R¹ peuvent en option être en une quelconque position libre;
R¹ est à chaque occurrence, de façon identique ou différente, une chaîne alkyle ou alcoxy en chaîne droite, ramifiée ou cyclique ayant 1 à 22 atomes de C, dans laquelle en addition, un ou plusieurs atomes de C non adjacent(s) peut/peuvent être remplacé(s) par -NR²-, -S-, -CO-O-, O-CO-O et dans laquelle un ou plusieurs atomes de H peut/peuvent être remplacé(s) par fluor, un groupe aryle ou aryloxy ayant 5 à 40 atomes de C, dans lequel, en addition, un ou plusieurs atomes de C peut/peuvent être remplacé(s) par O, S ou N et qui peut/peuvent être également substitué(s) par un ou plusieurs radicaux non aromatiques R¹, un groupe vinyle ou acétylène ou F, CI, Br, I, NO₂, CN, N(R²)₂, B(R²)₂, Si(R²)₃, dans lequel, en addition, deux ou plus de deux radicaux R¹ peut/peuvent former un système de cycle mono- ou polycyclique, aliphatique ou aromatique l'un avec l'autre;
R² est à chaque occurrence, de façon identique ou différente, H, une chaîne alkyle en chaîne droite, ramifiée ou cyclique ayant 1 à 22 atomes de C, dans lequel, en addition, un ou plusieurs atomes de C non adjacents peut/peuvent être remplacé(s) par O, S, -CO-O-, O-CO-O et dans lequel un ou plusieurs atomes de H peut/peuvent être remplacé(s) par fluor, un groupe aryle ayant 5 à 40 atomes de C, dans lequel, en addition, un ou plusieurs atomes de C peut/peuvent être remplacé(s) par O, S ou N et qui peut/peuvent être également substitué(s) par un ou plusieurs radicaux non aromatiques R²; deux ou plus de deux radicaux R² peuvent ici également former un système de cycle l'un avec l'autre;
n est à chaque occurrence, de façon identique ou différente, 0, 1, 2, 3 ou 4, étant entendu que n ne peut pas être 4 si une liaison à Y s'instaure à cette unité phényle, et que n ne peut pas être 3 ou 4 si toutes les liaisons à Y s'instaurent à cette unité phényle;
les composés qui suivent sont attendus ici:

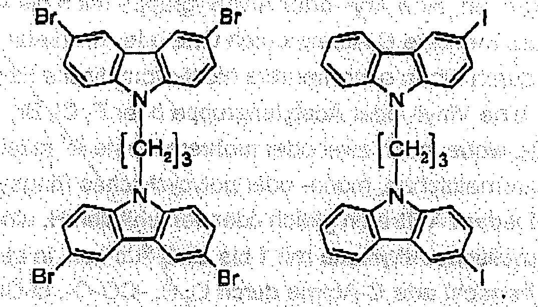

27. Composés selon la revendication 26, **caractérisés en ce que** Y est choisi parmi les groupes Cl, Br, I, O-tosylate, O-triflate, OSO₂R², B(OH)₂, B(OR²)₂, Sn(R²)₃ et NHR², dans lesquels R² a la même signification que dans la revendication 26.

28. Composés selon la revendication 26 et/ou 27, **caractérisés en ce que** les liaisons C-C et C-N sont choisies parmi les groupes du couplage SUZUKI, du couplage YAMAMOTO, du couplage STILLE et du couplage HARTWIG-BUCHWALD.

29. Composés selon une ou plusieurs des revendications 26 à 28, **caractérisés en ce que** les composés monomériques de la formule (LIX) conduisent à des unités structurelles des formules (III) à (XXXVIII) dans le polymère.

30. Utilisation d'un mélange ou d'un polymère selon une ou plusieurs des revendications 1 à 25 dans des diodes émettrices de lumière organiques (OLEDs), des cellules solaires organiques (O-SCs), des diodes laser organiques (O-lasers), des optiques non linéaires ou des détecteurs optiques organiques.

31. Composant électronique qui comprend une ou plusieurs couches active, dans lequel au moins une de ces couches comprend un ou plusieurs mélanges ou polymères selon une ou plusieurs des revendications 1 à 25.

32. Composant électronique selon la revendication 31, **caractérisé en ce qu'**il est une diode émettrice de lumière organique, une cellule solaire organique, une diode laser organique, un détecteur optique organique ou un dispositif pour des optiques non linéaires.
